(19) Europäisches Patentamt
European Patent Office
Office européen des brevets

(11) EP 3 114 174 B1

(12) **EUROPÄISCHE PATENTSCHRIFT**

(45) Veröffentlichungstag und Bekanntmachung des Hinweises auf die Patenterteilung:
**29.11.2017 Patentblatt 2017/48**

(21) Anmeldenummer: **15706488.2**

(22) Anmeldetag: **27.02.2015**

(51) Int Cl.:
***C09D 5/00*** *(2006.01)* ***C23C 14/00*** *(2006.01)*
***C23C 16/00*** *(2006.01)* ***G02B 1/00*** *(2006.01)*

(86) Internationale Anmeldenummer:
**PCT/EP2015/054151**

(87) Internationale Veröffentlichungsnummer:
**WO 2015/132152 (11.09.2015 Gazette 2015/36)**

(54) **MEHRSCHICHTAUFBAU MIT GUTEM UV- UND KRATZSCHUTZ**

MULTILAYER STRUCTURE WITH GOOD UV AND SCRATCH PROTECTION

STRUCTURE MULTICOUCHES DOTÉE D'UNE BONNE PROTECTION CONTRE LES UV ET CONTRE LES RAYURES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.03.2014 EP 14157652**

(43) Veröffentlichungstag der Anmeldung:
**11.01.2017 Patentblatt 2017/02**

(73) Patentinhaber: **Covestro Deutschland AG**
**51373 Leverkusen (DE)**

(72) Erfinder:
- **OSER, Rafael**
**47800 Krefeld (DE)**
- **KUHLMANN, Timo**
**42799 Leichlingen (DE)**
- **MERLI, Stefan**
**71131 Jettingen (DE)**
- **SCHULZ, Andreas**
**71229 Leonberg (DE)**
- **WALKER, Matthias**
**70839 Gerlingen (DE)**

(74) Vertreter: **Levpat**
**c/o Covestro AG**
**Gebäude 4825**
**51365 Leverkusen (DE)**

(56) Entgegenhaltungen:
**EP-A2- 0 285 870**
**EP-A2- 0 887 437**
**WO-A1-2006/002768**
**WO-A1-2012/143150**
**WO-A2-03/038141**
**DE-A1-102010 006 134**
**DE-C1- 10 012 516**
**US-A- 5 156 882**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die vorliegende Erfindung betrifft ein Mehrschichtaufbau enthaltend ein thermoplastisches Substrat, eine Sperrschicht, eine UV Schutzschicht sowie eine Deckschicht, der sich durch einen ausgezeichneten Abriebschutz sowie eine langfristige Alterungsbeständigkeit auszeichnen.

Die Nutzung von Thermoplasten in Außenanwendungen wird häufig erst durch eine zusätzlich aufgebrachte Schutzschicht auf dem thermoplastischen Trägermaterial möglich. Diese Schutzschicht hat die Aufgabe, das thermoplastische Trägermaterial vor mechanischen und chemischen Umwelteinflüssen sowie vor strahlungsbedingten Schädigungen zu schützen. Die Applikation von Beschichtungsstoffen, wie zum Beispiel eine Kombination von vor UV-Strahlung schützenden Haftschichten mit auf der Sol-Gel-Chemie basierten Kratzfestbeschichtungen, ist weit verbreitet und in einer Vielzahl von Außenanwendungen im Einsatz. Diese weisen neben ökonomischen Hürden auch technische Limitierungen auf. Die Applikation erfolgt bei optisch hochwertigen Bauteilen im Flutverfahren, wodurch ein Schichtdickengradient auf dem thermoplastischen Träger entsteht, welcher ursächlich für die Ausbildung nicht einheitlicher Schichteigenschaften ist. So hängt die Schichthärte als Maß für die Kratzfestigkeit oder Abriebbeständigkeit sowie die Alterungsbeständigkeit des lackierten Bauteils bei der Exposition durch schädliche UV-Strahlung neben der Zusammensetzung auch von den Schichtdicken der Einzelschichten ab. Die Güte und Qualität der auf diese Weise erzielten oberflächenmodifizierten Thermoplasten ist unter anderem wegen der Reproduzierbarkeit der gewünschten Eigenschaften limitiert.

Zur Überwindung vorgenannter Defizite wird als Alternative zur Applikation von fließfähigen Beschichtungsmitteln auf Schutzschichten gesetzt, die durch die physikalische oder chemische Gasphasenabscheidung auf dem thermoplastischen Trägermaterial abgeschieden werden. Nachteilig bei der physikalischen Gasphasenabscheidung wirkt der hohe Energieeintrag und damit verbunden hohe Temperatureintrag auf das zu modifizierende Trägermaterial. Thermoplastische Trägermaterialien, wie zum Beispiel Polymethylmethacrylat (PMMA) oder Polycarbonat (PC), können bei zu hohem Eintrag deformieren, wodurch wiederum die Güte des zu schützenden Bauteils vermindert ist. Die Nutzung der chemischen Gasphasenabscheidung zum Aufbau von Schutzschichten auf thermoplastischen Trägermaterialien ist weit verbreitet und somit mangelt es in der Literatur nicht an vielfältigen Ansätzen zur Bereitstellung von Schutzschichten für thermoplastische Trägermaterialien sowie Verfahren zur Abscheidung der jeweiligen Schutzschichten.

Zur Abscheidung von Deckschichten mittels der chemischen Gasphasenabscheidung werden häufig sogenannte Silizium-basierte Präkursoren, wie beispielsweise Silane, Disilane, Tetramethyldisiloxan (TMDSO), Hexamethyldisiloxan (HMDSO), Tetraethylorthosilikat (TEOS), Hexamethyldisilane, Octamethylcyclotetrasiloxan (D4) oder Tetramethylcyclotetrasiloxane, verwendet. Eine Auswahl wird in den Schriften DE2650048, EP0252870 und US5298587 angeführt. Diese Präkursoren scheiden sich dann nach Oxidation mit Sauerstoff als Siliziumdioxidschicht mit partiell regulierbarem organischen Anteil auf der Oberfläche des thermoplastischen Trägers ab.

Die Überwindung der unterschiedlichen thermischen Ausdehnungskoeffizienten von thermoplastischem Trägermaterial und der aufzubringenden Schicht wird durch die Ausbildung einer Gradientenschicht wie in den Schriften DE3413019, US4927704, US5051308, EP0267679 und WO 97/13802 exemplarisch beschrieben, erreicht. Hierbei ist zu erwähnen, dass die Gradientenschicht direkt an das thermoplastische Trägermaterial grenzt.

Bei der Abscheidung von Schichten zum Schutz vor UV-Strahlung mittels der chemischen Gasphasenabscheidung werden häufig metallorganische Verbindungen, wie beispielsweise Diethylzink (DEZ), Zinkacetat, Triisopropyltitanat, Tetraisopropyltitanant (TTIP), Cer-β-diketonat sowie Cerammoniumnitrat genutzt. Die resultierenden Schichten enthalten beispielsweise Titan, Cer, Eisen, Zink, Vanadium, Yttrium, Indium, Zinn und Zirkonium, wobei diese als abgeschiedenes Oxid, Nitrid oder Oxinitrid die Eigenschaft besitzen kurzwellige Strahlung im Wellenlängenbereich von 280 nm bis 380 nm zu absorbieren.

Die Verwendung unterschiedlicher Präkursoren sowie die Eigenschaften der resultieren UV-Lichtabsorbierenden anorganischen Schichten sind auszugsweise in den nachfolgenden Dokumenten näher erläutert.

- Nizard et al.: "Deposition of titanium dioxide from TTIP by plasma enhanced and remote plasma enhanced chemical vapour deposition" (2008), Surface and Coating Technology 202, Pages 4076-4085.
- H. J. Frenck et al.: "Depopsition of TiO2 thin films plasma-enhanced decomposition of tetraisopropyltitanate" (1991), Thin Solid Films, 201, Pages 327-335.
- Barreca et al.: Nucleation and growth of nanophasic CeO2 thin films by plasma enhanced CVD" (2003), Chemical Vapor Deposition 9, Pages 199-206.
- Kerstin Lau, "Plasmagestützte Aufdampfprozesse für die Herstellung haftfester optischer Beschichtungen auf Bisphenol-A Polycarbonat" (2006), Dissertation.

Die EP 887437 A beschreibt ein Verfahren zum Abscheiden eines haftenden Überzuges auf die Oberfläche eines Substrates durch Plasmaabscheidung, umfassend die Ausbildung eines sauerstoffhaltigen Plasmas durch einen Gleichstrom-Lichtbogenplasmagenerator, Injizieren eines Reaktantengases in das Plasma außerhalb des Plasmagenerators, Richten des Plasmas in eine Vakuumkammer durch einen divergierenden Düseninjektor, der sich vom Plasmagenerator in die Vakuumkammer zu dem Substrat erstreckt, das in der Vakuumkammer angeordnet ist, wodurch aus dem Sauerstoff und dem Reaktantengas gebildete reaktionsfähige Spezies die Oberfläche des Substrates für eine genügende Zeitdauer kontaktieren, um den haftenden Überzug zu bilden. Nachteilig bei der Verwendung des Gleichstrom-Lichtbogenplasmagenerators ist der hohe Energieeintrag auf das zu beschichtende Substrat, wodurch Deformationen auftreten können. Die resultierende Schutzschicht kann im Wesentlichen aus Siliziumoxid oder aus Zinkoxid bzw. Titanoxid bestehen. Eine Kombination der beiden Schichten wird nicht beschrieben. Zinkoxid als alleinige Schutzschicht ist nicht beständig gegen Hydrolyse und in der beschriebenen Form nicht dauerhaft nutzbar. Auf eine genaue Zusammensetzung der ZnO-Schicht wird nicht eingegangen.

Die DE10012516 umfasst ein Bauteil mit einer transparenten, kratzfesten und für UV-Strahlung undurchlässigen Schutzschicht, wobei die Schutzschicht eine Gradientenschicht ist, bestehend aus Silizium, Kohlenwasserstoffresten und einem Metall, ausgewählt aus einer Gruppe, deren Oxide UV-Strahlung absorbieren, wobei der Silizium und Sauerstoffgehalt nach außen hin zunimmt und der Metallgehalt in der Schicht ein Maximum aufweist und nach außen und bauteilseitig abfällt. Das Metall ist hierbei ausgewählt aus der Gruppe umfassend Titan, Cer, Eisen, Zink, Vanadium, Yttrium, Indium, Zinn und Zirkonium. Das gebildete Metalloxid wird in diesem Prozess in die sich ausbildende Kratzfestschicht eingebettet. Nachteilig sind die komplizierte Prozessführung bei der simultanen Abscheidung von mehreren Schichtbestandteilen sowie die mangelhafte Reproduzierbarkeit der Schichtgüte. Da das Metalloxid statistisch in der Matrix verteilt ist, kann bei einem derartigen Aufbau auch die Hydrolyse-Stabilität des Metalloxids nicht gewährleistet werden. Auf eine genaue Zusammensetzung der Metalloxid-Schicht wird nicht eingegangen.

Die DE10153760 betrifft ein Verfahren zur Herstellung UV-absorbierender transparenter Abriebschutzschichten durch Vakuumbeschichtung, bei dem gleichzeitig oder zeitlich unmittelbar nacheinander mindestens eine anorganische Verbindung, die Schichten mit hoher Abriebfestigkeit bildet, und eine anorganische Verbindung, die Schichten mit hoher UV-Absorption bildet, jeweils durch reaktive oder teilreaktive plasmagestützte Hochrate-Bedampfung auf einem Substrat abgeschieden werden. Als bevorzugte Ausführungsform wird die Abscheidung von Zinkoxid als UVabsorbierende Schicht eingebettet in Siliziumdioxid als Abriebschutzschicht beschrieben. Hierdurch wird das Zinkoxid vor äußeren Einflüssen geschützt. Auf eine genaue Zusammensetzung der Zinkoxid-Schicht wird nicht eingegangen. Nachteilig ist das gewählte Abscheideverfahren der Elektronenstrahl-Hochrateverdampfung von zum Beispiel Zinkoxid, da dieses Verfahren nur unter hohem Aufwand in den Prozess der chemischen Gasphasenabscheidung weiterer Schichten implementiert werden kann. Weiterhin werden hohe Prozesstemperaturen verwendet, um zu wirtschaftliche Raten zu gelangen, welche zur Deformation des thermoplastischen Trägermaterials führen können.

Die US 5156882 A beschreibt eine Methode zur Bildung eines transparenten, abrieb-resistenten und UV-Licht absorbierenden Bauteils enthaltend eine Zwischenschicht einer haftvermittelnden harzartigen Zusammensetzung, eine Schicht basierend auf einer UV-absorbierenden Zusammensetzung ausgewählt aus der Gruppe enthaltend Zinkoxid, Titandioxid, Cerdioxid und Vanadiumpentoxid auf der zuvor genannten Zwischenschicht sowie eine abschließende , abriebfeste Schicht auf der vorherigen Schicht, dadurch gekennzeichnet, dass alle Schichten durch Plasma-unterstützte chemische Gasphasenabscheidung (PE-CVD) abgeschieden wurden. Auf eine genaue Zusammensetzung der Metalloxid-Schicht und der Deckschicht wird nicht eingegangen. Ein Hinweis auf die Alterungsbeständigkeit der Schichtenfolge wird nicht angeführt. Weiterhin sind die erzielten Abscheideraten in dem genutzten Verfahren aufgrund der Verwendung eines Hochfrequenzplasmas nicht wirtschaftlich skalierbar.

Die DE19901834 beschreibt ein Verfahren in 6 Schritten zur Abscheidung eines 4-Schichtsystems auf Kunststoffen, wobei eine weiche, sauerstoffarme Deckschicht aus HMDSO ohne die Nutzung von Sauerstoff gebildet wird. Weiterhin wird ein organischer UV-Absorber bei der Abscheidung einer UV-Schutzschicht verwendet. Auch diese Schrift liefert keinen Hinweis über die stöchiometrischen Zusammensetzungen der Einzelschichten. Die Verwendung von organischen UV-Absorbern in dem Prozess der chemischen Gasphasenabscheidung führt nach heutiger Kenntnis zu nicht alterungsbeständigen Schichtsystemen mit begrenzter Schichtqualität. Dies wird durch die Schriften PCT/EP2013/067210 (nicht veröffentlicht), DE19924108, DE19522865, FR2874606 sowie der WO 1999/055471 weiter verdeutlicht.

WO 2012/143150 A1 beschreibt die Nutzung von Aluminiumoxid als Barriereschicht im Aufbau.

DE10 2010 006134 A1 beschreibt die Nutzung von SiO2 im Gegensatz zu SiOxCyHz der vorliegenden Anmedlung sowie den Einsatz von organischen UV Absorbern zur Abscheidung von absorbierenden Schichten.

Wo 2006/002768 A1 beschreibt dunkel eingefärbte, nicht transparente Aufbauten, die nicht auf dem Konzept der vorliegenden Erfindung beruhen.

WO2003/038141 A2 beschreibt einen durch Hochrateverdampfung hergestellten Schichtverbund aus SiOx / ZnOx / SiOx auf einem Substrat; es wird kein Gradient in der außenliegenden Schicht beschrieben.

Im Speziellen befassen sich die nachfolgenden Schriften mit UV-Schutzschichten basierend auf Zinkoxid zum

Schutz von Polycarbonat als thermoplastischen Träger. Eine genaue Empfehlung, wie das stöchiometrische Verhältnis im Zinkoxid in der UV-Schutzschicht zu wählen ist, um einen dauerhaften Alterungsschutz für das thermoplastische Substrat zu erhalten, wird nicht erwähnt. Weiterhin finden sich keine Ausführungen zum Einbau der UV-Schutzschicht in Funktionsschichten zur Eliminierung der Hydrolyse-Empfindlichkeit des Ausgangsmaterials. Die Ausführungsform einer potentiellen Deckschicht wird ebenfalls nicht thematisiert.

- Anma, H.: "Preparation of zinc oxide thin films deposited by plasma chemical vapor deposition for application to ultraviolet-cut coating" (2001), Japanese Journal of Applied Physics, Part 1: Regular Papers, Short Notes & Review Papers, Volume 40, Issue 10, Pages 6099-6103.

- Moustaghfir, A. et al.: "Sputtered zinc oxide coatings: structural study and application to the photoprotection of the polycarbonate" (2004), Surface and Coatings Technology, Volume 180-181, Pages 642-645, ISSN: 0257-8972.

- Moustaghfir, A. et al.: "Photostabilization of polycarbonate by ZnO coatings" (2005), Journal of Applied Polymer Science, Volume 95, Issue 2, Pages 380-385, ISSN: 0021-8995.

- Merli, S. et al.: "Hochrateabscheidung mit einem Mikrowellenplasma Mit Duo-Plasmaline abgeschiedenes Siliziumoxid verleiht Polycarbonat die Kratzfestigkeit von Glas" (2013), Vakuum in Forschung und Praxis, Volume 25, Issue 2, Pages 33-40, ISSN: 0947-076X.

- Merli, S. et al.: " PECVD of Zinc Oxide as UV Protection Coating" (2012), Jahresbericht 2012 des Instituts für Plasmaforschung Universität Stuttgart, Seite 46.

- Merli, S. et al.: "Transparent UV- and scratch protective coatings on polycarbonate" (2013), Jahresbericht 2013 des Instituts für Plasmaforschung Universität Stuttgart, Seite 14.

Im Stand der Technik findet sich demnach keine ausreichende Lehre zur Auslegung eines Schichtsystems für thermoplastische Trägermaterialien, das neben einem ausgezeichneten Abriebschutz auch eine langfristige Alterungsbeständigkeit gewährleistet. Weiterhin mangelt es an der genauen Beschreibung eines Verfahrens zur Erreichung dieser Eigenschaften unter Berücksichtigung wirtschaftlicher Aspekte.

Der vorliegenden Erfindung liegt die Aufgabe zu Grunde, Schichtsysteme für thermoplastische Trägermaterialien zur Verfügung zu stellen, die sich durch einen ausgezeichneten Abriebschutz sowie eine langfristige Alterungsbeständigkeit auszeichnen, welche in der Güte sowie Schichtstabilität im Stand der Technik nicht bekannt sind. Ein weiterer Bestandteil ist die Bereitstellung eines ökonomischen Verfahrens zur Herstellung derartiger Schichtsysteme auf thermoplastischen Substraten basierend auf einem Hochrateprozess sowie die Bereitstellung von Formkörpern, die nach dem Hochrateprozess hergestellt wurden. Der Gegenstand der vorliegenden Erfindung ist in den anhängenden Ansprüchen 1-19 definiert. Überraschenderweise wurde gefunden, dass die Aufgabe der vorliegenden Erfindung durch einen Mehrschichtaufbau gemäss Anspruch 1 gelöst wird. Die Schichten werden durch plasmaunterstützte chemische Gasphasenabscheidung auf dem thermoplastischen Träger abgeschieden.

**Thermoplastisches Trägermaterial**

Bei dem zu beschichtenden thermoplastischen Trägermaterial kann es sich um ein thermoplastisch verarbeitbares Material handeln.

Thermoplastisch verarbeitbare Materialien im Sinne der Erfindung sind vorzugsweise Polycarbonat, Co-Polycarbonat, Polyestercarbonat, Polystyrol, Styrol-Copolymere, aromatische Polyester wie Polyethylenterephthalat (PET), PET-Cyclohexandimethanol-Copolymer (PETG), Polyethylen-naphthalat (PEN), Polybutylenterephthalat (PBT), aliphatische Polyolefine wie Polypropylen oder Polyethylen, cyclisches Polyolefin, Poly- oder Copolyacrylate und Poly- oder Copolymethacrylat wie Poly- oder Copolymethylmethacrylate (wie PMMA) sowie Copolymere mit Styrol wie transparentes Polystyrolacrylnitril (PSAN), thermoplastische Polyurethane, Polymere auf Basis von zyklischen Olefinen (z.B. TOPAS®, ein Handelsprodukt der Firma Ticona), Polycarbonat Blends mit olefinischen Copolymeren oder Pfropfpolymeren, wie beispielsweise Styrol/Acrylnitril Copolymeren. Hierbei können die vorgenannten Polymere alleine oder in Mischungen eingesetzt werden.

Bevorzugt sind Polycarbonat, Co-Polycarbonat, Polyestercarbonat, aliphatische Polyolefine wie Polypropylen oder Polyethylen, cyclisches Polyolefin, PET oder PETG sowie Poly- oder Copolyacrylate und Poly- oder Copolymethacrylat wie Poly- oder Copolymethylmethacrylate als auch Mischungen vorgenannter Polymere.

Besonders bevorzugt sind Polycarbonat, Co-Polycarbonat, Polyestercarbonat, PET oder PETG sowie Poly- oder Copolyacrylate und Poly- oder Copolymethacrylat wie Poly- oder Copolymethylmethacrylate als auch Mischungen

vorgenannter Polymere.

Ganz besonders werden als thermoplastisches Trägermaterial (auch als Kunststoffsubstrat bezeichnet) ein Polycarbonat und/oder ein Co-Polycarbonat eingesetzt. Ferner ist auch ein Blendsystem, welches mindestens ein Polycarbonat oder Co-Polycarbonat enthält, bevorzugt.

Erfindungsgemäß können die Kunststoffsubstrate, auf die die nachfolgenden Schichten aufgetragen werden, aus einer oder mehreren Schichten aufgebaut sein sowie mit beliebigen anderen Schichten vorbeschichtet sein.

**Polycarbonate**

Polycarbonate im Sinn der Erfindung sind sowohl Homopolycarbonate, Copolycarbonate als auch Polyestercarbonate wie sie in EP 1 657 281 A beschrieben sind.

Die Herstellung aromatischer Polycarbonate erfolgt beispielsweise durch Umsetzung von Diphenolen mit Kohlensäurehalogeniden, vorzugsweise Phosgen und/oder mit aromatischen Dicarbonsäuredihalogeniden, vorzugsweise Benzoldicarbonsäuredihalogeniden, nach dem Phasengrenzflächenverfahren, gegebenenfalls unter Verwendung von Kettenabbrechern, beispielsweise Monophenolen und gegebenenfalls unter Verwendung von trifunktionellen oder mehr als trifunktionellen Verzweigern, beispielsweise Triphenolen oder Tetraphenolen. Ebenso ist eine Herstellung über ein Schmelzepolymerisationsverfahren durch Umsetzung von Diphenolen mit beispielsweise Diphenylcarbonat möglich.

Diphenole zur Herstellung der aromatischen Polycarbonate und/oder aromatischen Polyestercarbonate sind vorzugsweise solche der Formel (I)

(I), 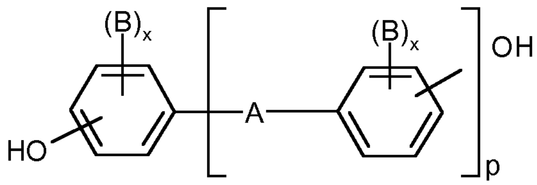 ,

wobei

A eine Einfachbindung, C1 bis C5-Alkylen, C2 bis C5-Alkyliden, C5 bis C6-Cycloalkyliden, -O-, -SO-, -CO-, -S-, -SO2-, C6 bis C12-Arylen, an das weitere aromatische gegebenenfalls Heteroatome enthaltende Ringe kondensiert sein können, oder ein Rest der Formel (II) oder (III)

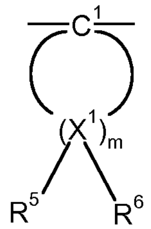

(II)

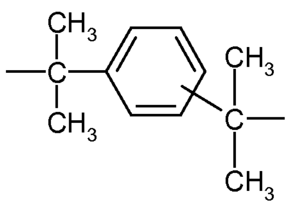

(III)

B jeweils C1 bis C12-Alkyl, vorzugsweise Methyl, Halogen, vorzugsweise Chlor und/oder Brom

x jeweils unabhängig voneinander 0, 1 oder 2,

p 1 oder 0 sind, und

R5 und R6 für jedes X1 individuell wählbar, unabhängig voneinander Wasserstoff oder C1 bis C6-Alkyl, vorzugsweise Wasserstoff, Methyl oder Ethyl,

X1 Kohlenstoff und m eine ganze Zahl von 4 bis 7, bevorzugt 4 oder 5 bedeuten, mit der Maßgabe, dass an mindestens einem Atom X1, R5 und R6 gleichzeitig Alkyl sind.

Für die Herstellung der Polycarbonate geeignete Diphenole sind beispielsweise Hydrochinon, Resorcin, Dihydroxydiphenyle, Bis-(hydroxyphenyl)-alkane, Bis(hydroxyphenyl)-cycloalkane, Bis-(hydroxyphenyl)-sulfide, Bis-(hydroxyphenyl)-ether, Bis-(hydroxyphenyl)-ketone, Bis-(hydroxyphenyl)-sulfone, Bis-(hydroxyphenyl)-sulfoxide, alpha-alpha'-bis-(hydroxyphenyl)-diisopropylbenzole, Phtalimidine abgeleitet von Isatin- oder Phenolphthaleinderivaten sowie deren kernalkylierte und kernhalogenierte Verbindungen.

Bevorzugte Diphenole sind 4,4'-Dihydroxydiphenyl, 2,2-Bis-(4-hydroxyphenyl)-propan, 2,4-Bis-(4-hydroxyphenyl)-2-methylbutan, 1,1-Bis-(4-hdydroxyphenyl)-p-diisopropylbenzol, 2,2-Bis-(3-methyl-4-hydroxyphenyl)-propan, 2,2-Bis-(3-chlor-4-hydroxyphenyl)-propan, Bis-(3,5-dimethyl-4-hydroxyphenyl)-methan, 2,2-Bis-(3,5-dimethyl-4-hydroxyphenyl)-propan, Bis-(3,5-dimethyl-4-hydroxyphenyl)-sulfon, 2,4-Bis-(3,5-dimethyl-4-hydroxyphenyl)-2-methylbutan, 1,1-Bis-(3,5-dimethyl-4-hydroxyphenyl)-p-diisopropylbenzol, 2,2-Bis-(3,5-dichlor-4-hydroxyphenyl)-propan, 2,2-Bis-(3,5-dibrom-4-hydroxyphenyl)-propan, 1,1-Bis-(4-hydroxyphenyl)-3,3,5-trimethylcyclohexan, und 2-Hydrocarbyl-3,3-Bis(4-Hydroxyaryl)phthalimidine sowie dem Reaktionsprodukt von N-Phenylisatin und Phenol.

Besonders bevorzugte Diphenole sind 2,2-Bis-(4-hydroxyphenyl)-propan, 2,2-Bis-(3,5-dimethyl-4-hydroxyphenyl)-propan, 2,2-Bis-(3,5-dichlor-4-hydroxyphenyl)-propan, 2,2-Bis-(3,5-dibrom-4-hydroxyphenyl)-propan, 1,1-Bis-(4-hydroxyphenyl)-cyclohexan und 1,1-Bis-(4-hydroxyphenyl)-3,3,5-trimethylcyclohexan. Im Fall der Homopolycarbonate ist nur ein Diphenol eingesetzt, im Fall der Copolycarbonate sind mehrere Diphenole eingesetzt. Geeignete Kohlensäurederivate sind beispielsweise Phosgen oder Diphenylcarbonat.

Geeignete Kettenabbrecher, die bei der Herstellung der Polycarbonate eingesetzt werden können, sind sowohl Monophenole als auch Monocarbonsäuren. Geeignete Monophenole sind Phenol selbst, Alkylphenole wie Kresole, p-tert.-Butylphenol, Cumylphenol, p-n-Octylphenol, p-iso-Octylphenol, p-n-Nonylphenol und p-iso-Nonylphenol, Halogenphenole wie p-Chlorphenol, 2,4-Dichlorphenol, p-Bromphenol und 2,4,6-Tribromphenol, 2,4,6-Trijodphenol, p-Jodphenol, sowie deren Mischungen. Bevorzugte Kettenabbrecher sind Phenol, Cumylphenol und/oder p-tert-Butylphenol.

Besonders bevorzugte Polycarbonate im Rahmen der vorliegenden Erfindung sind Homopolycarbonate auf Basis von Bisphenol A und Copolycarbonate auf Basis der Monomere ausgewählt aus mindestens einem der Gruppe aus Bisphenol A, 1,1-Bis-(4-hydroxyphenyl)-3,3,5-trimethylcyclohexan, 2-Hydrocarbyl-3,3-Bis(4-Hydroxyaryl)phthalimidine und den Reaktionsprodukten aus N-Phenylisatin und Phenol. Die Polycarbonate können in bekannter Weise linear oder verzweigt sein. Der Anteil der Co-Monomere bezogen auf Bisphenol A beträgt im Allgemeinen bis zu 60 Gew.-%, bevorzugt bis zu 50 Gew.-%, besonders bevorzugt 3 bis 30 Gew.-%. Mischungen von Homopolycarbonat und Copolycarbonaten können ebenfalls verwendet werden.

Polycarbonate und Co-Polycarbonate enthaltend 2-Hydrocarbyl-3,3-Bis(4-Hydroxyaryl)phthalimidine als Monomere sind unter anderem bekannt aus EP 1 582 549 A1. Polycarbonate und Co-Polycarbonate enthaltend Bisphenolmonomere basierend auf Reaktionsprodukten aus N-Phenylisatin und Phenol sind beispielsweise in WO 2008/037364 A1 beschrieben.

Ebenfalls geeignet sind Polycarbonat-Polysiloxan-Blockcokondensate. Dabei enthalten die Blockcokondensate bevorzugt Blöcke aus Dimethylsiloxan. Die Darstellung von Polysiloxan-Polycarbonat-Blockkokondensaten ist beispielsweise beschrieben in US 3 189 662 A, US 3 419 634 A sowie EP 0 122 535 A1. Bevorzugt enthalten die Blockcokondensate 1 Gew.-% bis 50 Gew.-%, bevorzugt 2 Gew.-% bis 20 Gew.-% Dimethylsiloxan.

Die thermoplastischen, aromatischen Polycarbonate haben mittlere Molekulargewichte (Gewichtsmittel Mw, gemessen durch GPC (Gelpermeationschromatographie mit Polycarbonatstandard) von 10.000 g/mol bis 80.000 g/mol bevorzugt 14.000 g/mol bis 32.000 g/mol, besonders bevorzugt 18.000 g/mol bis 32.000 g/mol. Im Falle spritzgegossener Polycarbonat-Formteile beträgt das bevorzugte mittlere Molekulargewicht 20.000 g/mol bis 29.000 g/mol. Im Falle von extrudierten Polycarbonat-Formteilen beträgt das bevorzugte mittlere Molekulargewicht 25.000 g/mol bis 32.000 g/mol.

Die thermoplastischen Kunststoffe der Trägerschicht können ferner Füllstoffe enthalten. Füllstoffe haben in der vorliegenden Erfindung die Aufgabe den thermischen Ausdehnungskoeffizienten des Polycarbonates zu verringern sowie die Permeabilität von Gasen und Wasserdampf zu regulieren, bevorzugt zu verringern. Als Füllstoffes sind Glaskugeln, Glashohlkugeln, Glasflakes, Ruße, Graphite, Kohlenstoffnanoröhrchen, Quarze, Talk, Glimmer, Silikate, Nitride, Wollastonit, sowie pyrogene oder gefällte Kieselsäuren, wobei die Kieselsäuren BET-Oberflächen von mindestens 50 m2/g (nach DIN 66131/2) aufweisen, geeignet.

Bevorzugte faserförmige Füllstoffe sind metallische Fasern, Kohlenstofffasern, Kunststofffasern, Glasfasern oder gemahlene Glasfasern, besonders bevorzugt sind Glasfasern oder gemahlene Glasfasern.

Bevorzugte Glasfasern sind auch solche, die in der Ausführungsform Endlosfaser (rovings), Langglasfasern und Schnittglasfasern verwendet werden, die aus M-, E-, A-, S-, R- oder C-Glas herstellt werden, wobei E-, A-, oder C-Glas weiter bevorzugt sind. Der Durchmesser der Fasern beträgt bevorzugt 5 μm bis 25 μm, weiter bevorzugt 6 μm bis 20 μm, besonders bevorzugt 7 μm bis 15 μm. Langglasfasern weisen bevorzugt eine Länge von 5 μm bis 50 mm, weiter bevorzugt von 5 μm bis 30 mm, noch weiter bevorzugt von 6 μm bis 15 mm, und besonders bevorzugt von 7 μm bis

12 mm auf; sie sind beispielsweise in der WO 2006/040087 A1 beschrieben. Die Schnittglasfasern weisen bevorzugt zu mindestens 70 Gew.-% der Glasfasern eine Länge von mehr als 60 µm auf. Weitere anorganische Füllstoffe sind anorganische Partikel mit Korngestalt, ausgewählt aus der Gruppe, die sphärische, kubische, tafelförmige, diskusförmige und plättchenförmige Geometrien umfasst. Insbesondere geeignet sind anorganische Füllstoffe mit sphärischer oder plättchenförmig, bevorzugt in feinteiliger und/oder poröser Form mit großer äußerer und/oder innerer Oberfläche. Dabei handelt es sich bevorzugt um thermisch inerte anorganische Materialien insbesondere basierend auf Nitride wie Bornitrid, um Oxide oder Mischoxide wie Ceroxid, Aluminiumoxid, um Carbide wie Wolframcarbid, Siliciumcarbid oder Borcarbid gepulvertem Quarz wie Quarzmehl, amorphes SiO2, gemahlener Sand, Glaspartikel wie Glaspulver, insbesondere Glaskugeln, Silikate oder Alumosilikate, Graphit, insbesondere hochreiner synthetischer Graphit. Insbesondere bevorzugt sind dabei Quarz und Talk, am stärksten bevorzugt Quarz (sphärische Korngestalt). Diese Füllstoffe sind durch einen mittleren Durchmesser d50% von 0,1 µm bis 10 µm, vorzugsweise von 0,2 µm bis 8,0 µm, weiter bevorzugt von 0,5 µm bis 5 µm, gekennzeichnet.

Silikate sind durch einen mittleren Durchmesser d50% von 2 µm bis 10 µm, vorzugsweise von 2,5 µm bis 8,0 µm, weiter bevorzugt von 3 µm bis 5 µm, und besonders bevorzugt von 3 µm, gekennzeichnet, wobei ein oberer Durchmesser d95% von entsprechend 6 µm bis 34 µm, weiter bevorzugt von 6,5 µm bis 25,0 µm, noch weiter bevorzugt von 7 µm bis 15 µm, und besonders bevorzugt von 10 µm bevorzugt ist. Bevorzugt weisen die Silikate eine spezifische BET-Oberfläche, bestimmt durch Stickstoffadsorption gemäß ISO 9277, von 0,4 m2/g bis 8,0 m2/g, weiter bevorzugt von 2 m2/g bis 6 m2/g, und besonders bevorzugt von 4,4 m2/g bis 5,0 m2/g auf. Weiter bevorzugte Silikate weisen nur maximal 3 Gew.-% Nebenbestandteile auf, wobei vorzugsweise der Gehalt an Al2O3 < 2,0 Gew.-%, Fe2O3 < 0,05 Gew.-%, (CaO + MgO) < 0,1 Gew.-%, (Na2O + K2O) < 0,1 Gew.-%) ist, jeweils bezogen auf das Gesamtgewicht des Silikats.

Weitere Silikate verwenden Wollastonit oder Talk in Form von fein vermahlenen Typen mit einem mittleren Partikeldurchmesser d50 von < 10 µm bevorzugt < 5 µm, besonders bevorzugt < 2 µm, ganz besonders bevorzugt < 1,5 µm. Die Korngrößenverteilung wird durch Windsichten bestimmt. Die Silikate können eine Beschichtung mit siliziumorganischen Verbindungen haben, wobei bevorzugt Epoxysilan-, Methylsiloxan-, und Methacrylsilan-Schlichten zum Einsatz kommen. Besonders bevorzugt ist eine Epoxysilanschlichte.

Die Füllstoffe können in einer Menge bis zu 40 Gew.-% bezogen auf die Menge an Polycarbonat zugesetzt werden. Bevorzugt sind 2,0 Gew.-% bis 40,0 Gew.-%, besonders bevorzugt 3,0 Gew.-% bis 35,0 Gew.-%.

Als Blendpartner für die thermoplastischen Kunststoffe, insbesondere für Polycarbonate, sind Pfropfpolymerisate von Vinylmonomeren auf Pfropfgrundlagen wie Dienkautschuke oder Acrylatkautschuke geeignet. Pfropfpolymerisate B sind bevorzugt solche aus B.1 5 Gew.-% bis 95 Gew.-%, vorzugsweise 30 Gew.-% bis 90 Gew.-%, wenigstens eines Vinylmonomeren auf B.2 95 Gew.-% bis 5 Gew.-%, vorzugsweise 70 Gew.-% bis 10 Gew.-% einer oder mehrerer Pfropfgrundlagen mit Glasübergangstemperaturen < 10°C, vorzugsweise < 0°C, besonders bevorzugt < -20°C. Die Pfropfgrundlage B.2 hat im Allgemeinen eine mittlere Teilchengröße (d50-Wert) von 0,05 µm bis 10 µm, vorzugsweise 0,1 µm bis 5 µm, besonders bevorzugt 0,2 µm bis 1 µm. Monomere B.1 sind vorzugsweise Gemische aus B.1.1 50 bis 99 Gew.-Teilen Vinylaromaten und/oder kernsubstituierten Vinylaromaten (wie Styrol, *-Methylstyrol, p-Methylstyrol, p-Chlorstyrol) und/oder Methacrylsäure-(C1-C8)-Alkylester, wie Methylmethacrylat, Ethylmethacrylat), und B.1.2 1 µm bis 50 Gew.-Teilen Vinylcyanide (ungesättigte Nitrile wie Acrylnitril und Methacrylnitril) und/oder (Meth)Acrylsäure-(C1-C8)-Alkylester, wie Methylmethacrylat, n-Butylacrylat, t-Butylacrylat, und/oder Derivate (wie Anhydride und Imide) ungesättigter Carbonsäuren, beispielsweise Maleinsäureanhydrid und N-Phenyl-Maleinimid. Bevorzugte Monomere B.1.1 sind ausgewählt aus mindestens einem der Monomere Styrol, * Methylstyrol und Methylmethacrylat, bevorzugte Monomere B.1.2 sind ausgewählt aus mindestens einem der Monomere Acrylnitril, Maleinsäureanhydrid und Methylmethacrylat. Besonders bevorzugte Monomere sind B.1.1 Styrol und B.1.2 Acrylnitril.

Für die Pfropfpolymerisate B geeignete Pfropfgrundlagen B.2 sind beispielsweise Dienkautschuke, EP(D)M-Kautschuke, also solche auf Basis Ethylen/Propylen und gegebenenfalls Dien, Acrylat-, Polyurethan-, Silikon-, Chloropren und Ethylen/Vinylacetat-Kautschuke. Bevorzugte Pfropfgrundlagen B.2 sind Dienkautschuke, beispielsweise auf Basis Butadien und Isopren, oder Gemische von Dienkautschuken oder Copolymerisate von Dienkautschuken oder deren Gemischen mit weiteren copolymerisierbaren Monomeren (z.B. gemäß B.1.1 und B.1.2), mit der Maßgabe, dass die Glasübergangstemperatur der Pfropfgrundlage B.2 unterhalb 10°C vorzugsweise < 0°C, besonders bevorzugt < 10°C liegt. Besonders bevorzugt ist reiner Polybutadienkautschuk.

Besonders bevorzugte Polymerisate B sind beispielsweise ABS-Polymerisate (Emulsions-, Masse- und Suspensions-ABS), wie sie z.B. in der DE 2 035 390 A1 oder in der DE 2 248 242 A1 bzw. in Ullmanns, Enzyklopädie der Technischen Chemie, Bd. 19 (1980), S. 280 ff. beschrieben sind. Der Gelanteil der Pfropfgrundlage B.2 beträgt mindestens 30 Gew.- %, vorzugsweise mindestens 40 Gew.-% (in Toluol gemessen). Die Pfropfcopolymerisate B werden durch radikalische Polymerisation, z.B. durch Emulsions-, Suspensions-, Lösungs- oder Massepolymerisation, vorzugsweise durch Emulsions- oder Massepolymerisation hergestellt. Da bei der Pfropfreaktion die Pfropfmonomeren bekanntlich nicht unbedingt vollständig auf die Pfropfgrundlage aufgepfropft werden, werden unter Pfropfpolymerisaten B auch solche Produkte verstanden, die durch (Co)Polymerisation der Pfropfmonomere in Gegenwart der Pfropfgrundlage

gewonnen werden und bei der Aufarbeitung mit anfallen. Die Polymer-Zusammensetzungen können optional noch weitere übliche Polymeradditive enthalten, wie z.B. die in EP 0 839 623 A1, WO 96 15102 A1, EP 0 500 496 A1 oder "Plastics Additives Handbook", Hans Zweifel, 5th Edition 2000, Hanser Verlag, München) beschriebenen Antioxidantien, Thermostabilisatoren, Entformungsmittel, optischen Aufheller, UV-Absorber und Lichtstreumittel in den für die jeweiligen Thermoplasten üblichen Mengen.

Als UV-Stabilisatoren sind Benzotriazole, Triazine, Benzophenone und/oder arylierte Cyanoacrylate geeignet. Besonders geeignete UV-Absorber sind Hydroxy-Benzotriazole, wie 2-(3',5'-Bis-(1,1-dimethylbenzyl)-2'-hydroxy-phenyl)-benzotriazol (Tinuvin® 234, BASF SE, Ludwigshafen), 2-(2'-Hydroxy-5'-(tert-octyl)-phenyl)-benzotriazol (Tinuvin® 329, BASF SE, Ludwigshafen), 2-(2'-Hydroxy-3'-(2-butyl)-5'-(tert-butyl)-phenyl)-benzotriazol (Tinuvin® 350, BASF SE, Ludwigshafen), Bis-(3-(2H-benztriazolyl)-2-hydroxy-5-tert.-octyl)methan, (Tinuvin® 360, BASF SE, Ludwigshafen), (2-(4,6-Diphenyl-1,3,5-triazin-2-yl)-5-(hexyloxy)-phenol (Tinuvin® 1577, BASF SE, Ludwigshafen), sowie der Benzophenone 2,4-Dihydroxy-benzophenon (Chimasorb® 22 , BASF SE, Ludwigshafen) und 2-Hydroxy-4-(octyloxy)-benzophenon (Chimasorb® 81, BASF SE, Ludwigshafen), 2-Propenoic acid, 2-Cyano-3,3 -diphenyl-, 2,2-Bis[[(2-cyano-1-oxo-3,3 -diphenyl-2-propenyl)oxy] -methyl] -1,3-propanediylester (9CI) (Uvinul® 3030, BASF SE, Ludwigshafen), 2-[2-Hydroxy-4-(2-ethylhexyl)oxy]phenyl-4,6-di(4-phenyl)phenyl-1,3,5-triazine (Tinuvin® 1600, BASF SE, Ludwigshafen) oder Tetra-ethyl-2,2'-(1,4-phenylen-dimethyliden)-bismalonat (Hostavin® B-Cap, Clariant AG). Die Zusammensetzung der thermoplastischen Kunststoffe kann UV-Absorber üblicherweise in einer Menge von 0 bis 10 Gew.-%, bevorzugt 0,001 Gew.-% bis 7,000 Gew.-%, besonders bevorzugt 0,001 Gew.-% bis 5,000 Gew.-% bezogen auf die Gesamtzusammensetzung enthalten. Die Herstellung der Zusammensetzungen der thermoplastischen Kunststoffe erfolgt mit gängigen Einarbeitungsverfahren durch Zusammenführung, Vermischen und Homogenisieren der einzelnen Bestandteile, wobei insbesondere die Homogenisierung bevorzugt in der Schmelze unter Einwirkung von Scherkräften stattfindet. Gegebenenfalls erfolgt das Zusammenführen und Vermischen vor der Schmelzehomogenisierung unter Verwendung von Pulvervormischungen.

Der thermoplastisch verarbeitbare Kunststoff kann zu Formkörpern in Form von Folien oder Platten verarbeitet werden. Die Folie oder die Platte können ein oder mehrschichtig ausgeführt sein und aus verschiedenen oder gleichen Thermoplasten bestehen, z.B. Polycarbonat/PMMA, Polycarbonat/PVDF oder Polycarbonat/PTFE aber auch Polycarbonat/Polycarbonat.

Der thermoplastisch verarbeitbare Kunststoff kann beispielsweise durch Spritzguss oder Extrusion geformt werden. Durch Einsatz von einem oder mehreren Seitenextrudern und einer Mehrkanal-Düse oder gegebenenfalls geeigneten Schmelzeadaptern vor einer Breitschlitzdüse lassen sich thermoplastische Schmelzen verschiedener Zusammensetzung übereinander legen und somit mehrschichtige Platten oder Folien erzeugen (für die Koextrusion siehe beispielsweise EP-A 0 110 221, EP-A 0 110 238 und EP-A 0 716 919, für Details des Adapter- und Düsenverfahrens siehe Johannaber/Ast:"Kunststoff- Maschinenführer", Hanser Verlag, 2000 und in Gesellschaft Kunststofftechnik: "Koextrudierte Folien und Platten: Zukunftsperspektiven, Anforderungen, Anlagen und Herstellung, Qualitätssicherung", VDI-Verlag, 1990). Für die Coextrusion werden bevorzugt Polycarbonate und Poly(meth)acrylate eingesetzt. Besonders bevorzugt werden Polycarbonate eingesetzt.

Die Folie kann verformt und mit einem weiteren Thermoplasten aus den oben genannten Thermoplasten hinterspritzt werden (Film Insert Molding (FIM)). Platten können thermogeformt oder mittels Drape-Forming bearbeitet bzw. kalt eingebogen werden. Auch ist eine Formgebung über Spritzguss-Prozesse möglich. Diese Prozesse sind dem Fachmann bekannt. Die Dicke der Folie oder Platte muss hierbei so beschaffen sein, dass im Bauteil eine hinreichende Steifigkeit gewährleistet ist. Im Falle einer Folie kann diese durch Hinterspritzen verstärkt werden, um eine ausreichende Steifigkeit zu gewährleisten.

Die Gesamtdicke des Formkörpers, hergestellt aus dem thermoplastisch verarbeitbaren Kunststoff, das heißt einschließlich einer möglichen Hinterspritzung oder Koextrusionsschichten, beträgt im Allgemeinen 0,1 mm bis 15 mm. Vorzugsweise beträgt die Dicke der Formkörper 0,8 mm bis 10 mm. Insbesondere beziehen sich die Dickenangaben auf die Gesamtformkörperdicke bei Verwendung von Polycarbonat als Formkörpermaterial einschließlich einer möglichen Hinterspritzung oder Koextrusionsschichten.

**Plasmagestützte Chemische Gasphasenabscheidung**

Ein Plasma im Sinne der Erfindung ist ein Gas, dessen Bestandteile teilweise oder vollständig in Ionen und Elektronen "aufgeteilt" sind. Das bedeutet, ein Plasma enthält freie Ladungsträger. Ein Niederdruckplasma ist ein Plasma, in dem der Druck erheblich niedriger als der Erdatmosphärendruck ist. Niederdruckplasmen zählen zu den nichtthermischen Plasmen, das heißt, die einzelnen Bestandteile des Plasmas (Ionen, Elektronen, Neutralteichen) stehen nicht im thermischen Gleichgewicht miteinander. Typische technische Niederdruckplasmen werden im Druckbereich kleiner 100 mbar betrieben, also bei Drücken, die um einen Faktor 10 geringer sind als der normale Luftdruck. Bei technischen Niederdruckplasmen werden durch selektive Anregung der Elektronen Elektronentemperaturen von einigen Elektronenvolt (mehreren 10.000 K) erreicht, während die Temperatur des Neutralgases wenig über Zimmertemperatur liegt.

Dadurch können auch thermisch sensible Materialien wie Kunststoffe mittels Niederdruckplasmen bearbeitet werden. Die Wechselwirkung des Plasmas mit dem Werkstück findet dabei einfach durch in Kontakt bringen statt.

Geeignete Verfahren im Sinne dieser Anmeldung zur Erzeugung eines technischen Plasmas sind solche, die mittels elektrischer Entladung bei gegenüber dem Normaldruck von 1013 mbar verringertem Druck unter Einsatz einer Gleichspannung, einer Hochfrequenz- oder Mikrowellenanregung gezündet werden. Diese Verfahren sind in der Technik unter der Bezeichnung Niederdruck- oder Niedertemperaturplasma bekannt.

Bei dem Niederdruckplasmaverfahren befindet sich das zu behandelnde Werkstück in einer mittels Pumpen evakuierbaren Vakuumkammer.

Diese Vakuumkammer umfasst mindestens eine Elektrode, wenn das Plasma durch elektrische Anregung mittels Gleichspannung oder durch Hochfrequenzfelder angeregt wird. Als Anregungsfrequenz können beispielsweise dienen: 13,56 MHz, 27,12 MHz, oder bevorzugt 2,45 GHz. Für den bevorzugten Fall, dass die Anregung mittels Mikrowellenstrahlung erfolgt, könnte sich zum Beispiel an einer Stelle der Kammerwand ein Bereich befinden, welcher für Mikrowellenstrahlung durchlässig ist und durch welchen die Mikrowellenstrahlung in die Kammer eingekoppelt wird. Eine andere bevorzugte Möglichkeit besteht darin, die Mikrowellenleistung entlang einer mikrowellendurchlässigen Röhre, beispielsweise aus Quarzglas, einzukoppeln. Eine derartige Anordnung heißt Duo-Plasmaline (entwickelt am IGVP (vormals IPF), Universität Stuttgart (E. Räuchle., Lecture at: "Third International Workshop on microwave Discharges: Fundamentals and Applications", Abbaye de Fontevraud, France, 20-25 April 1997; W. Petasch et al. "Duo-Plasmaline - A linearly extended homogenous low pressure plasma source", Surface and Coatings Technology 93 (1997), 112-118), kommerziell erhältlich z.B. bei Muegge Electronic GmbH, Reichelsheim, Germany). Diese Mikrowellenquellen werden typischerweise durch zwei 2,45 GHz-Magnetrons betrieben. Das Plasma brennt dann entlang der Röhren und lässt sich so leicht auf große Werkstücke ausdehnen.

Plasmapolymerisation wird im Sinne der Erfindung synonym mit plasmagestützter chemischer Gasphasenabscheidung (PECVD) verwendet. Plasmapolymerisation ist beispielsweise in "G. Benz: Plasmapolymerisation: Überblick und Anwendung als Korrosions- und Zerkratzungsschutzschichten. VDI-Verlag GmbH Düsseldorf, 1989" oder in "Vakuumbeschichtung Bd.2 - Verfahren, H. Frey, VDI-Verlag Düsseldorf 1995" definiert.

Dabei werden dampfförmige Vorläuferverbindungen (Präkursoren) in der Vakuumkammer durch ein Plasma zunächst aktiviert. Durch die Aktivierung entstehen ionisierte Moleküle, und es bilden sich bereits in der Gasphase erste Molekülfragmente in Form von Clustern oder Ketten. Die anschließende Kondensation dieser Fragmente auf der Substratoberfläche bewirkt dann unter Einwirkung von Substrattemperatur, Elektronen- und Ionenbeschuss die Polymerisation und somit die Bildung einer geschlossenen Schicht.

Schichtbildende Präkursoren sind beispielsweise Silane oder Siloxane, die in die Vakuumkammer dampfförmig eingebracht und mittels eines $O_2$-Plasmas zu $SiO_x$ bzw. zu kohlenstoffhaltigem $SiO_xC_yH_z$ oxidiert werden, die sich als glasartige Schicht auf dem Substrat niederschlagen. Die in den Präkursoren auch vorhandenen Anteile wie Kohlenstoff und Wasserstoff reagieren dabei zum Teil zu kohlenstoffhaltigen Gasen und auch zu Wasser ab. Dabei lässt sich durch die Konzentration von Präkursoren zum Sauerstoffgas die Härte, das E-Modul, der Brechungsindex, die chemische Zusammensetzung sowie die Morphologie der Schichten einstellen. Geringe SauerstoffKonzentrationen und hohe Kohlenstoffkonzentrationen führen dabei eher zu zähen Schichten, während hohe Sauerstoffkonzentrationen und geringe Kohlenstoffkonzentrationen glasartig harte Schichten erzeugen.

Bei der Abscheidung mehrerer aufeinanderfolgender Schichten kann das Vakuum in der Beschichtungskammer unterbrochen oder auch nicht unterbrochen werden. In einer bevorzugten Ausführungsform wird das Vakuum in der Vakuumkammer zwischen den Beschichtungsschritten nicht unterbrochen.

**Sperrschicht**

Auf dem thermoplastischen Trägermaterial wird eine haftvermittelnde Sperrschicht durch plasmaunterstützte chemische Gasphasenabscheidung von Präkursoren abgeschieden. Die Sperrschicht hat die Aufgabe die Diffusion von Bestandteilen aus dem thermoplastischen Trägermaterial zu verhindern. Des Weiteren besteht die Aufgabe der Sperrschicht darin das thermoplastische Material vor äußeren Einflüssen wie Luft oder Feuchtigkeit zu schützen bzw. deren Einfluss auf das thermoplastische Trägermaterial zu verringern. Weiterhin muss die Sperrschicht den direkten Kontakt des thermoplastischen Trägermaterials mit der UV-absorbierenden Schicht verhindern, da je nach Ausführungsform eine gewisse photo-katalytische Aktivität der UV-Absorbierenden Schicht existiert, welche zum partiellen Abbau der thermoplastischen Trägerschicht führen kann. Dies hätte eine verminderte Alterungsbeständigkeit zur Folge.

Geeignete Silizium-basierte Präkursoren sind beispielsweise ausgewählt aus der Gruppe enthaltend Hexamethyldisiloxan (HMDSO), Octamethyltrisiloxan, Decamethyltetrasiloxan, Dodecamethylpentasiloxan, Hexamethylcyclotrisiloxan, Octamethylcyclotetrasiloxan (D4), Decamethylcyclopentasiloxane, Dodecamethylcyclohexasiloxane, Tetramethylcyclotetrasiloxane, Tetraethoxysilan, Tetramethyldisiloxan (TMDSO), Trimethoxymethylsilan, Dimethyldimethoxysilan, Hexamethyldisilazan, Triethoxyphenylsiloxan oder Vinyltrimethylsilan.

Bevorzugt sind Präkursoren aus der Gruppe Hexamethyldisiloxan, Octamethylcyclotetrasiloxan (D4), Tetramethylcyclotetrasiloxane, Tetraethoxysilan (TEOS), Tetramethyldisiloxan, Trimethoxymethylsilan, Dimethyldimethoxysilan, Hexamethyldisilazan, Triethoxyphenylsiloxan oder Vinylsilan. Besonders bevorzugt werden TEOS, Hexamethyldisiloxan (HMDSO) und Octamethylcyclotetrasiloxan (D4) verwendet.

Weiterhin geeignet sind die Halogenide der Elemente Ti, Zr, Hf, V, Nb, Ta, Mo, W, Re, Os, B, Al, C, Si, Ge, Sn, As sowie Sb als Präkursor für die Schichtabscheidung durch plasmaunterstützte chemische Gasphasenabscheidung. Beispiele für zuvor genannte Halogenide sind Trichlorethylsilan, Trichlorborid, Tetrachlortitanat, Trifluorborid, Tetrachlorsilan, Trichloraluminat und Zirkonium(IV)chlorid. Bevorzugte Halogenide sind die Chloride der oben genannten Elemente, besonders bevorzugt sind Tetrachlortitanat, Tetrachlorsilan und Trichlorethylsilan.

Weiterhin geeignet sind die Carbonyle der Elemente V, Cr, Mo, W, Mn, Tc, Re, Fe, Ru, Os, Co und Ni als Präkursor für die Schichtabscheidung durch chemische Gasphasenabscheidung.

Weiterhin geeignet sind die Hydride der Elemente B, C, Si, Ge, Sn, N, P, As und Sb als Präkursor für die Schichtabscheidung durch chemische Gasphasenabscheidung.

Weiterhin geeignet sind die Alkyle der Elemente Ti, Zr, Hf, Zn, Cd, Hg, Al, Ga, In, C, Si, Ge, Sn, Pb, N, P, As, Be, Hg, Mg, Bi, Se, Te und Sb als Präkursor für die Schichtabscheidung durch plasmaunterstützte chemische Gasphasenabscheidung. Beispiele für zuvor genannte Alkyle sind Diisobutylaluminiumhydrid, Triethylaluminat, Triisobutylaluminat, Trimethylaluminat, Triethylantimon, Trimethylantimon, Triisopropylantimon, Stiban ($SbH_3$), Triethylarsen, Trimethylarsen, Monoethylarsan, Tertiarybutylarsan, Arsin ($AsH_3$), Diethylberyllium, Trimethylbismuth, Dimethylcadmium, Diethylcadmium, Allylmethylcadmium, Triethylgallium, Trimethylgallium, Tetramethylgermanium, Tetraethylgermanium, Isobutylgermanium, Dimethylaminogermaniumtrichlorid, Triethylindium, Trimethylindium, Diisopropylmethylindium, Ethyldimethylindium, Bis(cyclopentadienyl)magnesium, Dimethylquecksilber, Triethylphosphin, Trimethylphosphin, Diethylselenid, Dimethylselenid, Diisopropylselenid, Triethylsilan, Diethyltellurid, Dimethyltellurid, Diisopropyltellurid, Tetraethylzinn, Tetramethylzinn, Diethylzink, Diemethylzink, Trisopropyltitanat und Tetraisopropyltitinat. Bevorzugt sind die Alkyle der Elemente Titan und Zink.

Neben den Halogeniden, Carbonylen, Hydriden sowie Alkylen sind die Alkoholate, Diketonate, Cyclopentadienyl-Verbindungen, Amido-Komplexe sowie PF3-Komplexe zuvor genannter Elemente als Präkursor für die Schichtabscheidung durch plasmaunterstützte chemische Gasphasenabscheidung geeignet. Bevorzugt werden die Elemente Cu, Pd, Pt, Ag, Au, Co, Rh und Ir als Cyclopentadienyl-Verbindung, β-Diketonat sowie mit einem Chelatbildner, wie zum Beispiel 1,1,1,5,5,5-Hexafluoracetylenaceton, 2,2-Dimethyl-6,6,7,7,8,8,8-heptafluor-3,5-octandion, Acetylaceton, 2,2,6,6-Tetramethylheptan-3,5-dion sowie 1,1,1-Trifluor-2,4-pentandion, verwendet.

Weiterhin geeignet als Präkursor für die plasmaunterstützte chemische Gasphasenabscheidung sind Acetylen, Benzol, Hexafluorobenzol, Styrol, Ethylen, Tetrafluorethylen, Cyclohexan, Oxiran, Acrylsäure, Propionsäure, Vinylacetat, Methylacrylat, Hexamethyldisilan, Tetramethyldisilan sowie Divinyltetramethyldisiloxan.

Weiterhin geeignet als Präkursor für die chemische Gasphasenabscheidung sind Vinylferrocen, 1,3,5-Trichlorbenzol, Chlorbenzol, Styrol, Ferrocen, Picolin, Naphthalin, Pentamethylbenzol, Nitrotoluol, Acrylnitril, Diphenylselenid, p-Toluidin, p-Xylol, N,N-Dimethyl-p-toluidin, Toluol, Anilin, Diphenylquecksilber, Hexamethylbenzol, Malonnitril, Tetracyanethylen, Thiopen, Benzolselenol, Tetrafluorethylen, Ethylen, N-Nitrosodiphenylamin, Thianthren, Acetylen, N-Nitrosopiperidin, Dicyanoketenethylacetal, Cyamelurin, 1,2,4-Trichlorbenzol, Propan, Thioharnstoff, Thioacetamid, N-Nitrosodiethylamin, Hexa-n-butyl(di)zinn sowie Triphenylarsin.

Als Reaktivgas werden beispielsweise Sauerstoff, Luft, Distickstoffoxid, Stickoxide, Stickstoff, Wasserstoff, Kohlendioxid, Methan, Wasser, niedermolekulare Kohlenwasserstoffe und Ammoniak eingesetzt. Bevorzugt werden Sauerstoff, Distickstoffoxid und Stickstoff eingesetzt.

Zusätzlich zum Reaktivgas kann ein Trägergas Verwendung finden. Als Trägergas werden Helium, Neon, Argon, Krypton, Xenon, Stickstoff und Kohlendioxid eingesetzt. Bevorzugt werden Argon, Stickstoff und Kohlendioxid eingesetzt.

In einer bevorzugten Ausführungsform der Sperrschicht besteht diese je nach verwendetem Trägergas sowie Reaktivgas aus einem Oxid, Mischoxid, Nitrid oder Oxinitrid der vorgenannten Elemente oder deren Mischungen.

In einer besonders bevorzugten Ausführungsform besteht die Sperrschicht aus Siliziumdioxid oder kohlenstoffhaltigem $SiO_xC_yH_z$.

In einer Ausführungsform werden die Gasflüsse des Präkursoren und des Reaktivgases in einem konstanten Verhältnis zu einander gehalten, wobei der Gasfluss des Reaktivgases größer ist als der Gasfluss des Präkursors.

In einer weiteren Ausführungsform durchläuft der Sauerstoffgehalt, der Stickstoffgehalt und / oder der Kohlenstoffgehalt in der resultierenden Sperrschicht einen Gradienten oder einen stufenartige Gehaltsänderung, bevorzugt in der Art, dass der Sauerstoffgehalt oder der Stickstoffgehalt in der Nähe des thermoplastischen Trägers am geringsten und der Kohlenstoffgehalt am höchsten ist.

In einer weiteren Ausführungsform durchlaufen der Sauerstoffgehalt, der Stickstoffgehalt und / oder der Kohlenstoffgehalt in der resultierenden Sperrschicht ein Maximum oder Minimum.

In einer weiteren Ausführungsform ist die resultierende Sperrschicht an der dem thermoplastischen Träger abgewandten Seite frei von organischen Bestandteilen, wie beispielsweise Kohlenwasserstoffresten.

Die Dicke der Sperrschicht ist kleiner 5 μm, bevorzugt kleiner 3 μm, besonders bevorzugt kleiner 1,5 μm.

Die Plasmaleistung zur Abscheidung der Sperrschicht beträgt in einer weiteren Ausführungsform 2 x 1 bis 2 x 3 kW, bezogen auf eine Array-Anordnung aus 4 Duo-Plasmalines mit 28 cm Länge (Leistungsdichte = 1786 W/m - 5357 W/m) und einem Druckbereich von 0,1 - 1,5 mbar, wobei die Leistung im Dauerstrichmodus eingetragen wird. Die Mindestleistung der Mikrowellenzufuhr ergibt sich aus der Bedingung, dass für eine gegebene Duo-Plasmaline-Konfiguration und bei gegebenen Gasflüssen sowie Drücken das Plasma zündet und sich homogen um die Duo-Plasmalines ausbildet.

In einer weiteren Ausführungsform beträgt die Zeit zur Abscheidung der Sperrschicht in 1 μm Dicke bevorzugt kleiner 20 s, besonders bevorzugt kleiner 15 s und ganz besonders bevorzugt kleiner 10 s.

**UV-Schutzschicht**

Für die Abscheidung der UV-Schutzschicht durch chemische Gasphasenabscheidung werden als Präkursoren Metallverbindungen eingesetzt, deren Metalle als solche oder zusammen mit Silizium UVabsorbierende Oxide, Oxinitride oder Nitride bilden und die einen genügend hohen Dampfdruck aufweisen. Beispiele sind Carbonyle, Metallocene, Alkyle, Nitrate, Acetylacetonate, Acetate oder Alkoxyverbindungen der Metalle Cer, Zink, Titan, Vanadium, Yttrium, Indium, Eisen, Zinn und Zirkonium. Hierbei kann es erforderlich sein, dem Sauerstoffplasma Stickstoff oder Edelgase, wie zum Beispiel Argon, zuzusetzen.

Bevorzugt werden als Präkursoren Diethylzink, Zinkacetat, Triisopropyltitanat, Tetraisopropyltitanat, Cer-β-diketonat und Cerammoniumnitrat eingesetzt.

In einer Ausführungs bestehen die UV-Schutzschichten bevorzugt aus Zinkoxid, Titandioxid, Ceroxid oder Vanadiumpentoxid, ganz besonders bevorzugt aus Zinkoxid, Titandioxid und Ceroxid.

In einer weiteren Ausführungsform wird eine UV-Schutzschicht bestehend aus mindestens 2 Metallen als Mischoxid abgeschieden. Beispiele für derartige Mischoxide sind Indiumzinnoxid (ITO), Antimonzinnoxid (ATO), Aluminiumzinkoxid (AZO) und Indiumzinkoxid (IZO) sowie Mischoxide aus den zuvor genannten Metallen.

Die Dicke der UV-Schutzschicht bei Abwesenheit weiterer UV absorbierender Schichten ist derart gewählt, dass die optische Dichte der Schicht bei 340 nm Wellenlänge bevorzugt > 2, besonders bevorzugt > 2,5 beträgt. Die bevorzugte Dicke liegt demnach zwischen 50nm und 5μm, besonders bevorzugt zwischen 100nm und 2μm und ganz besonders bevorzugt zwischen 0,4μm und 1,5μm.

In einer weiteren Ausführungsform ist die UV-Schutzschicht durch andere Schichten unterbrochen, beispielsweise durch eine Zwischenschicht, wodurch die Schichtspannung kontrolliert wird.

Zur Ausbildung einer möglichst stabilen UV-Schutzwirkung ist das $Me_y/O_x$-Verhältnis größer 1, bevorzugt größer 1,2 zu wählen.

Die Plasmaleistung zur Abscheidung der UV-Schutzschicht beträgt in einer weiteren Ausführungsform 2 x 1 kW - 2 x 3 kW, bezogen auf eine Array-Anordnung aus 4 Duo-Plasmalines mit 28 cm Länge (Leistungsdichte = 1786 W/m - 5357 W/m) und einem Druckbereich von 0,1 - 1,5 mbar, wobei diese im Dauerstrichmodus eingetragen wird. Die Mindestleistung der Mikrowellenzufuhr ergibt sich aus der Bedingung, dass für eine gegebene Duo-Plasmaline-Konfiguration und bei gegebenen Gasflüssen sowie Drücken das Plasma zündet und sich homogen um die Duo-Plasmalines ausbildet.

**Deckschicht**

Die Aufgabe der Deckschicht besteht darin, die UV-Schutzschicht vor äußeren Einflüssen wie beispielsweise Feuchtigkeit und Medien zu schützen. Weiterhin besteht die Aufgabe der Bereitstellung einer Oberfläche, welche Kratzfestigkeit und Abriebfestigkeit sowie eine einwandfreie Oberfläche bietet, welche frei von Fehlstellen und Einschlüssen ist.

Geeignete Silizium-basierte Präkursoren sind beispielsweise ausgewählt aus der Gruppe enthaltend Hexamethyldisiloxan (HMDSO), Octamethyltrisiloxan, Decamethyltetrasiloxan, Dodecamethylpentasiloxan, Hexamethylcyclotrisiloxan, Octamethylcyclotetrasiloxan (D4), Decamethylcyclopentasiloxane, Dodecamethylcyclohexasiloxane, Tetramethylcyclotetrasiloxane, Tetraethoxysilan (TEOS), Tetramethyldisiloxan (TMDSO), Trimethoxymethylsilan, Dimethyldimethoxysilan, Hexamethyldisilazan, Triethoxyphenylsiloxan oder Vinyltrimethylsilan.

Bevorzugt sind Präkursoren aus der Gruppe Hexamethyldisiloxan, Octamethylcyclotetrasiloxan, Tetramethylcyclotetrasiloxane, Tetraethoxysilan (TEOS), Tetramethyldisiloxan, Trimethoxymethylsilan, Dimethyldimethoxysilan, Hexamethyldisilazan, Triethoxyphenylsiloxan oder Vinylsilan. Besonders bevorzugt werden TEOS, Hexamethyldisiloxan (HMDSO) und Octamethylcyclotetrasiloxan (D4) verwendet.

Weiterhin geeignet sind die Halogenide der Elemente Ti, Zr, Hf, V, Nb, Ta, Mo, W, Re, Os, B, Al, C, Si, Ge, Sn, As sowie Sb als Präkursor für die Schichtabscheidung durch chemische Gasphasenabscheidung. Beispiele für zuvor genannte Halogenide sind Trichlorethylsilan, Trichlorborid, Tetrachlortitanat, Trifluorborid, Tetrachlorsilan, Trichloraluminat und Zirkonium(IV)chlorid. Bevorzugte Halogenide sind die Chloride der oben genannten Elemente, besonders

bevorzugt sind Tetrachlortitanat, Tetrachlorsilan und Trichlorethylsilan.

Weiterhin geeignet sind die Carbonyle der Elemente V, Cr, Mo, W, Mn, Tc, Re, Fe, Ru, Os, Co und Ni als Präkursor für die Schichtabscheidung durch chemische Gasphasenabscheidung.

Weiterhin geeignet sind die Hydride der Elemente B, C, Si, Ge, Sn, N, P, As und Sb als Präkursor für die Schichtabscheidung durch chemische Gasphasenabscheidung.

Weiterhin geeignet sind die Alkyle der Elemente Ti, Zr, Hf, Zn, Cd, Hg, Al, Ga, In, C, Si, Ge, Sn, Pb, N, P, As, Be, Hg, Mg, Bi, Se, Te und Sb als Präkursor für die Schichtabscheidung durch chemische Gasphasenabscheidung. Beispiele für zuvor genannte Alkyle sind Diisobutylaluminiumhydrid, Triethylaluminat, Triisobutylaluminat, Trimethylaluminat, Triethylantimon, Trimethylantimon, Triisopropylantimon, Stiban ($SbH_3$), Triethylarsen, Trimethylarsen, Monoethylarsan, Tertiarybutylarsan, Arsin ($AsH_3$), Diethylberyllium, Trimethylbismuth, Dimethylcadmium, Diethylcadmium, Allylmethylcadmium, Triethylgallium, Trimethylgallium, Tetramethylgermanium, Tetraethylgermanium, Isobutylgermanium, Dimethylaminogermaniumtrichlorid, Triethylindium, Trimethylindium, Diisopropylmethylindium, Ethyldimethylindium, Bis(cyclopentadienyl)magnesium, Dimethylquecksilber, Triethylphosphin, Trimethylphosphin, Diethylselenid, Dimethylselenid, Diisopropylselenid, Triethylsilan, Diethyltellurid, Dimethyltellurid, Diisopropyltellurid, Tetraethylzinn, Tetramethylzinn, Diethylzink, Diemethylzink, Trisopropyltitanat und Tetraisopropyltitinat. Bevorzugt sind die Alkyle der Elemente Titan, Silizium und Zink.

Neben den Halogeniden, Carbonylen, Hydriden sowie Alkylen sind die Alkoholate, Diketonate, Cyclopentadienyl-Verbindungen, Amido-Komplexe sowie PF3-Komplexe zuvor genannter Elemente als Präkursor für die Schichtabscheidung durch chemische Gasphasenabscheidung geeignet. Bevorzugt werden die Elemente Cu, Pd, Pt, Ag, Au, Co, Rh und Ir als Cyclopentadienyl-Verbindung, β-Diketonat sowie mit einem Chelatbildner, wie zum Beispiel 1,1,1,5,5,5-Hexafluoracetylenaceton, 2,2-Dimethyl-6,6,7,7,8,8,8-heptafluor-3,5-octandion, Acetylaceton, 2,2,6,6-Tetramethylheptan-3,5-dion sowie 1,1,1-Trifluor-2,4-pentandion, verwendet.

Weiterhin geeignet als Präkursor für die chemische Gasphasenabscheidung sind Acetylen, Benzol, Hexafluorobenzol, Styrol, Ethylen, Tetrafluorethylen, Cyclohexan, Oxiran, Acrylsäure, Propionsäure, Vinylacetat, Methylacrylat, Hexamethyldisilan, Tetramethyldisilan sowie Divinyltetramethyldisiloxan.

Weiterhin geeignet als Präkursor für die chemische Gasphasenabscheidung sind Vinylferrocen, 1,3,5-Trichlorbenzol, Chlorbenzol, Styrol, Ferrocen, Picolin, Naphthalin, Pentamethylbenzol, Nitrotoluol, Acrylnitril, Diphenylselenid, p-Toluidin, p-Xylol, N,N-Dimethyl-p-toluidin, Toluol, Anilin, Diphenylquecksilber, Hexamethylbenzol, Malonnitril, Tetracyanethylen, Thiopen, Benzolselenol, Tetrafluorethylen, Ethylen, N-Nitrosodiphenylamin, Thianthren, Acetylen, N-Nitrosopiperidin, Dicyanoketenethylacetal, Cyamelurin, 1,2,4-Trichlorbenzol, Propan, Thioharnstoff, Thioacetamid, N-Nitrosodiethylamin, Hexa-n-butyl(di)zinn sowie Triphenylarsin.

Als Reaktivgas werden Sauerstoff, Luft, Distickstoffoxid, Stickoxide, Stickstoff, Wasserstoff, Kohlendioxid, Methan, Wasser, niedermolekulare Kohlenwasserstoffe und Ammoniak eingesetzt. Bevorzugt werden Sauerstoff, Distickstoffoxid und Stickstoff eingesetzt.

Zusätzlich zum Reaktivgas kann ein Trägergas Verwendung finden. Als Trägergas werden Helium, Neon, Argon, Krypton, Xenon, Stickstoff und Kohlendioxid eingesetzt. Bevorzugt werden Argon, Stickstoff und Kohlendioxid eingesetzt.

In einer bevorzugten Ausführungsform der Deckschicht besteht diese je nach verwendetem Trägergas sowie Reaktivgas aus einem Oxid, Mischoxid, Nitrid oder Oxinitrid der vorgenannten Elemente oder deren Mischungen.

In einer besonders bevorzugten Ausführungsform besteht die Deckschicht aus Siliziumdioxid oder kohlenstoffhaltigem $SiO_xC_yH_z$.

In einer bevorzugten Ausführungsform durchläuft der Sauerstoffgehalt, der Stickstoffgehalt und / oder der Kohlenstoffgehalt in der resultierenden Deckschicht einen kontinuierlichen Gradienten und keine stufenartige Gehaltsänderung, bevorzugt in der Art, dass der Sauerstoffgehalt oder Stickstoffgehalt in der Nähe der UV-Schutzschicht am geringsten und der Kohlenstoffgehalt am höchsten ist. Der Sauerstoffgehalt der Deckschicht nahe der UV-Lichtabsorbierenden Schicht ist geringer als auf der entgegengesetzten Seite der Deckschicht und der Kohlenstoffgehalt nahe der UV-Lichtabsorbierenden Schicht ist höher als auf der entgegengesetzten Seite der Deckschicht.

In einer weiteren Ausführungsform durchläuft der Sauerstoffgehalt, der Stickstoffgehalt und / oder der Kohlenstoffgehalt in der resultierenden Deckschicht ein Maximum oder Minimum.

In einer weiteren Ausführungsform ist die resultierende Deckschicht an der von der UV-Schutzschicht abgewandten Seite frei von organischen Bestandteilen, wie beispielsweise Kohlenwasserstoffresten.

In einer weiteren Ausführungsform weist die Deckschicht eine Trübungszunahme von kleiner 10 %, bevorzugt kleiner 6 % und besonders bevorzugt kleiner 3 % nach der Beanspruchung nach ASTM D 1044 mittels Taber Abraser Modell 5131 nach 1000 Zyklen auf.

Die Dicke der Deckschicht liegt bevorzugt zwischen 1 μm und 15 μm, besonders bevorzugt zwischen 2 μm und 12 μm und ganz besonders bevorzugt zwischen 3 μm und 10 μm.

Die Plasmaleistung zur Abscheidung der Sperrschicht beträgt in einer weiteren Ausführungsform 2 x 1 bis 2 x 3 kW, bezogen auf eine Array-Anordnung aus 4 Duo-Plasmalines mit 28 cm Länge (Leistungsdichte = 1786 W/m - 5357

W/m) und einem Druckbereich von 0,1 - 1,5 mbar, wobei diese im Dauerstrichmodus eingetragen wird. Die Mindestleistung der Mikrowellenzufuhr ergibt sich aus der Bedingung, dass für eine gegebene Duo-Plasmaline-Konfiguration und bei gegebenen Gasflüssen sowie Drücken das Plasma zündet und sich homogen um die Duo-Plasmalines ausbildet.

## Weitere Funktionsschichten

Auf der Deckschicht können durch chemische oder physikalische Gasphasenabscheidung ein oder mehrere Schichten abgeschieden werden.

Als Funktionsschicht können unter anderem nichtleitende Oxide {$TiO_2$, $ZrO_2$, $ZrSi_xO_y$, $HfO_2$, $HfSi_xO_y$, $Ln_2O_3$, $LnSi_xO_y$, $LnAlO_3$, $SiO_2$, $Ta_2O_5$ und $Nb_2O_5$}, ferro-elektrische Oxide {$SrTiO_3$, $(Ba,Sr)TiO_3$, $Pb(Zr,Ti)O_3$, $SrBi_2(Ta_xNb_{1-x})_2O_9$, $Bi_4Ti_3O_{12}$, $Pb(Sc,Ta)O_3$ und $Pb(Mg,Nb)O_3$}, Ferrite {$(Ni,Zn)Fe_2O_4$, $(Mn,Zn)Fe_2O_4$}, Supraleiter {$YBa_2Cu_2O_{7-x}$, Bi-Sr-Ca-Cu-O}, leitende Oxide {$(La,Sr)CoO_3$, $(La,Mn)O_3$, $RuO_2$, $SrRuO_3$}, leitende Oxide mit geringem Emissionsgrad {F-dotiertes $SnO_2$ und Sndotiertes $In_2O_3$}, elektro-chrome oder photochrome Oxide {$WO_3$ und $MoO_3$}, thermo-chrome Oxide {$VO_2$}, selbst-reinigende Schichten {$TiO_2$}, Metallschichten {Al, W, Cu, Au, Ag, Pt, Pd, Ni, Ti, Cr, Mo, Ru, Ta}, Metallnitride {AlN, $Si_3N_4$, TiN, ZrN, HfN, TaN, NbN, WN, MoN, BN} sowie Metallcarbide {TiC, ZrC, HfC, $Cr_7C_3$, $Cr_3C_2$, WC, $W_2C$, $W_3C$, V-Carbid, Ta, Nb-Carbid, SiC, GeC, BC} Verwendung finden.

In einer weiteren Ausführungsform ist die Funktionsschicht in dem Mehrschichtaufbau enthalten.

In einer weiteren Ausführungsform wird bei dem Vorhandensein einer weiteren Funktionsschicht auf die Deckschicht verzichtet.

## Bevorzugte Aufbauten und Eigenschaften des Multischichtaufbaus

In einer weiteren Ausführungsform weist der Mehrschichtaufbau eine Anfangstrübung ermittelt nach ASTM D 1003 kleiner 3 %, bevorzugt kleiner 2,5 % und besonders bevorzugt kleiner 2,0 % auf.

In einer weiteren Ausführungsform weist der Mehrschichtaufbau einen Anfangsgelbwert ermittelt nach ASTM E 313 kleiner 3,0, bevorzugt kleiner 2,5 und besonders bevorzugt kleiner 2,0 auf.

In einer weiteren Ausführungsform weist der Mehrschichtaufbau keine Enthaftung nach Haftungsprüfungen nach ASTM D 3359 sowie ISO 2409 auf.

In einer weiteren Ausführungsform weist der Mehrschichtaufbau nach der Alterung nach ASTM G155 nach 4000 Stunden bzw. nach einem Energieeintrag von 10,8 $MJ/m^2$ bei 340nm eine Trübung ermittelt nach ASTM D 1003 kleiner 7,0 %, bevorzugt kleiner 5,0 % und besonders bevorzugt kleiner 4,0 % auf.

In einer weiteren Ausführungsform weist der Mehrschichtaufbau nach der Alterung nach ASTM G155 nach 4000 Stunden bzw. nach einem Energieeintrag von 10,8 $MJ/m^2$ bei 340nm einen Gelbwert ermittelt nach ASTM E 313 kleiner 7,5, bevorzugt kleiner 6,5 und besonders bevorzugt kleiner 5,5 auf. Des Weiteren treten nach der Alterung nach ASTM G155 nach 4000 Stunden bzw. nach einem Energieeintrag von 10,8 $MJ/m^2$ bei 340nm keine Risse im Aufbau bzw. keine Delamination der Schichten vom thermoplastischen Träger auf.

In einer bevorzugten Ausführungsform ist die Gesamtdicke der Einzelschichten auf dem thermoplastischen Träger kleiner 20$\mu$m, besonders bevorzugt kleiner 15$\mu$m und ganz besonders bevorzugt kleiner 10$\mu$m.

In einer weiteren Ausführungsform erfüllt die Anlage, die zur Abscheidung der Schichten genutzt wird, die Bedingung, dass der Quotient aus Pumpleistung in $m^3/h$ und Volumen der Vakuumkammer in $m^3$ mindestens 10.000 1/h, bevorzugt größer 75.000 1/h ist.

In einer bevorzugten Ausführungsform ist der Druck in der Vakuumkammer bei maximaler Pumpleistung sowie bei maximalen Gasflüssen von Präkursoren, Trägergasen und Reaktivgasen in Abwesenheit des zur Abscheidung benötigen Plasmas kleiner 1,5 mbar, besonders bevorzugt kleiner 1 mbar und ganz besonders bevorzugt kleiner 0,5 mbar.

## Beispiele

Die nachfolgenden Beispiele erläutern die Herstellung der Mehrschichtaufbauten sowie deren prinzipiellen Aufbau ohne auf die angeführten Beispiele beschränkt zu sein.

Als thermoplastischer Träger wurde ein lineares Polycarbonat auf Basis von Bisphenol-A mit einem MVR von ca. 9,5 g / 10 min (gemäß ISO 1133, bei 300 °C und 1,2 kg Belastung), welches kommerziell unter dem Namen Makrolon® M2808 von Bayer MaterialScience AG erhältlich ist, genutzt.

Nachfolgend werden die verwendeten Materialien zur Herstellung der Mehrschichtaufbauten tabellarisch aufgeführt.

| Materialien | CAS-Nummer | Hersteller |
|---|---|---|
| HMDSO - Hexamethyldisiloxan | 107-46-0 | Aldrich |

(fortgesetzt)

| Materialien | CAS-Nummer | Hersteller |
|---|---|---|
| DEZ - Diethylzink | 557-20-0 | Aldrich |
| Sauerstoff | 7782-44-7 | Linde |
| Aluminiumblech | | handelsüblich |

**Beschreibung der Beschichtungsanlage "Plasmodul"**

Das "Plasmodul" ist ein modular aufgebautes Vakuumgefäß für die plasmatechnologische Oberflächenbehandlung und Schichtabscheidung im Niederdruck. Das Plasmodul ist aus verschiedenen Modulen aufgebaut, wovon jedes einen bestimmten Zweck im Beschichtungsprozess erfüllt.

Figur 1 zeigt eine Skizze des Beschichtungsreaktors "Plasmodul":

> (a) Anschluss für die Vakuumpumpe, (b) Diagnostikmodul, (c) Substrathaltermodul, (d) Quellenmodul, (e) Abstandring, (f) Modul für die Precursor-Gaszuführung, (g) Modul für die $O_2$-Gaszuführung, (h) Boden, (i) Gasauslass für den Precursor, (j) Gasauslass $O_2$, (k) Substrathalter (1) Array aus 4 Duo-Plasmalines, (m) Plasmazone, (o) Schienenführung für den Substrathalter, (p) Dichtring, (q) Mikrowellenabschirmung

Im Quellenmodul (d) befindet sich die Plasmaquelle, die aus einem Array aus vier Duo-Plasmalines (1) besteht. Auf der Außenseite des Moduls sind Anschlüsse für die Mikrowellenversorgung der Plasmaquelle angebracht. Unter dem Quellenmodul (d) befinden sich die Module für die Präkursor-Gaszuführung (f) und für die Sauerstoff-Gaszuführung (g) sowie der Boden (h). Die Zufuhr der Prozessgase erfolgt somit räumlich getrennt voneinander. An der Außenseite der Präkursor- und Sauerstoffgaszuführungsmodule sind Anschlüsse für die jeweiligen Gaszuleitungen installiert. Über dem Quellenmodul (d) sind das Substrathaltermodul (c), das Diagnostikmodul (b) und der Anschluss für die Vakuumpumpe (a) angebracht. Die Abstände der einzelnen Module zueinander können durch Abstandsringe (e) verändert werden.

Die Gaszuführung für den Präkursor (i) ist aus Rohren aufgebaut und besitzt 16 Gasauslässe, deren Enden sich mittig zwischen den Duo-Plasmalines befinden. Um eine homogene Gasverteilung an die Gasauslässe zu gewährleisten, sind die Zuleitungen fraktal aufgebaut. Die Gaszuführung für Sauerstoff (j) besteht aus einem Rohr, welches sich in der Mitte des Plasmoduls in zwei Teile horizontal aufteilt. Der Sauerstoff verteilt sich zunächst homogen im unteren Bereich der Kammer und strömt dann aufwärts in Richtung Vakuumpumpe. Dabei muss der Sauerstoff durch die Plasmazone (m) hindurch, die sich um die Duo-Plasmalines (1) bildet. Der Substrathalter (k) besteht aus einer Kupferplatte der Größe 17 cm * 17 cm, an dessen Unterseite mittels Klammern die Substrate befestigt werden können. Der Substrathalter ist mittels einer Schienenführung (o) zum Be- und Entladen herausziehbar. Das Diagnostikmodul (b) besitzt mehrere Anschlussflansche für die Installierung von Diagnostiken und Messgeräten. Am Diagnostikmodul sind ein Manometer zur Druckmessung und ein Ventil zur Belüftung der Anlage angebracht. Die einzelnen Module besitzen eine Dichtfläche auf der Unterseite und zwei Nuten auf der Oberseite für den Einsatz von Dichtringen (p) zur Vakuumabdichtung zwischen den Modulen und elastische Metalldrahtgeflechtringe (q) zur Abschirmung der Mikrowellen.

Die Gesamthöhe des Plasmoduls beträgt ca. 58 cm und der Durchmesser 35 cm.

Für die Anlagenperipherie wird ein Verdampfersystem für HMDSO mit 9 bis 450 g/h und ein Pumpstand mit 2000 $m^3$/h, bestehend aus einer Kombination von Wälzkolbenpumpe mit Schraubenvorvakuumpumpe, verwendet. Sauerstoff steht mit bis zu 25 slm zur Verfügung und das Plasma kann mit bis zu 2 x 3 kW = 6 kW Dauerstrich (cw) oder 2 x 10 kW = 20 kW gepulster Mikrowellenleistung betrieben werden.

**Beschreibung der Schichtabscheidung**

Vorbereitung und Einschalten der Anlage:

> Die Oberfläche des thermoplastischen Trägermaterials wird mit geeigneten Mitteln, wie Entionisierung der Oberfläche oder Abblasen mit Öl-freier Druckluft, von Staubpartikeln und anderen Verunreinigungen gereinigt.

Zum Einbau des thermoplastischen Trägermaterials in die Beschichtungskammer befindet sich die Anlage im abgeschalteten Zustand, d.h. die Beschichtungskammer ist belüftet, die Vakuumpumpe und die Mikrowellenversorgung sind ausgeschaltet und alle Absperrventile für die Gasversorgung sind geschlossen. Das thermoplastische Trägermaterials wird mit der zu beschichtenden Seite nach unten und mit Hilfe der Klemmvorrichtung an den Substrathalter angebracht. Der Substrathalter wird anschließend eingefahren.

Der Kühlwasserkreislauf für die Magnetrons und die Vakuumpumpe wird aktiviert. Die Vakuumpumpe wird bei offenem Butterfly-Ventil eingeschaltet. Die Verdampfer bzw. die Heizung der Präkursoren sowie die Heizung der Zuleitungen werden eingeschaltet und auf den gewünschten Wert gestellt (circa. 70 °C für HMDSO, 20 - 40 °C für DEZ). Das Steuerungsgerät für die Massenflussregler bzw. -messer für die Präkursoren und den Sauerstoff wird eingeschaltet und die Kommunikation mit dem PC hergestellt. Das Netzteil für die Mikrowellenversorgung wird eingeschaltet und die Steuerungssoftware am PC gestartet. In der Steuerungssoftware wird der Dauerstrichmodus (cw, continuous wave) ausgewählt und auf externe Triggerung gestellt. Die Kühlluftversorgung der Duo-Plasmalines wird aktiviert. Nach dem Erreichen des Ausgangsdrucks von circa 0,5 - 1,0 Pa kann mit der Beschichtung begonnen werden.

Abscheidung der Schichten 2 (Sperrschicht) und 4 (Deckschicht):

Für die Abscheidung der Schichten 2 und 4 wird der Präkursor HMDSO (Hexamethyldisiloxan) verwendet. Die Absperrventile für die HMDSO- und $O_2$-Versorgung werden geöffnet. Es wird darauf geachtet, dass in der Beschichtungskammer ein Vakuum herrscht und die Gase nicht mit Luft in Kontakt kommen. Die gewünschten Gasflüsse werden über die Steuerungssoftware der Massenflussregler eingestellt. Die gewünschte Mikrowellenleistung wird per Software eingestellt. Die gewünschte Beschichtungsdauer wird über eine Zeitschaltuhr geregelt, die ein Steuerungssignal an das Mikrowellennetzteil ausgibt. Nachdem sich der Arbeitsdruck in der Beschichtungskammer stabilisiert hat, wird durch das Einschalten der Zeitschaltuhr die Mikrowelle aktiviert und die Beschichtung gestartet. Am Leuchten des Plasmas ist zu erkennen, dass der Beschichtungsprozess läuft. Nach dem Ablauf der eingestellten Beschichtungszeit wird die Mikrowelle deaktiviert und das Plasma erlischt. Die Gasflüsse für HMDSO und $O_2$ werden anschließend auf null geregelt.

Abscheidung der Schicht 3 (UV-Schutzschicht):

Für die Abscheidung der Schicht 3 wird der Präkursor DEZ (Diethylzink) verwendet. Die Absperrventile für die DEZ- und $O_2$-Versorgung werden geöffnet. Es ist darauf zu achten, dass in der Beschichtungskammer ein Vakuum herrscht und die Gase nicht mit Luft in Kontakt kommen. Die gewünschten Gasflüsse werden über die Steuerungssoftware der Massenflussregler bzw. über ein Justierventil eingestellt. Die gewünschte Mikrowellenleistung wird per Software eingestellt. Die gewünschte Beschichtungsdauer wird über eine Zeitschaltuhr geregelt, die ein Steuerungssignal an das Mikrowellennetzteil ausgibt. Nachdem sich der Arbeitsdruck in der Beschichtungskammer stabilisiert hat, wird durch das Einschalten der Zeitschaltuhr die Mikrowelle aktiviert und die Beschichtung gestartet. Am Leuchten des Plasmas ist zu erkennen, dass der Beschichtungsprozess läuft. Nach dem Ablauf der eingestellten Beschichtungszeit wird die Mikrowelle deaktiviert und das Plasma erlischt. Die Gasflüsse für DEZ und $O_2$ werden anschließend auf null geregelt.

Bei der Abscheidung der Kombinationen aus Schichten 2 bis 4 wird das Vakuum in der Beschichtungskammer nicht unterbrochen.

Abschalten der Anlage und Entladen des thermoplastischen Trägermaterials

Alle Absperrventile für die Gaszuführungen werden geschlossen. Anschließend wird das Butterfly-Ventil geschlossen und die Vakuumpumpe ausgeschaltet. Zur Belüftung der Anlage wird das Belüftungsventil langsam geöffnet. Nach dem Belüften wird der Substrathalter herausgefahren und die beschichtete Probe entnommen.

**Prüfmethoden**

Die Alterung der Mehrschichtaufbauten erfolgte nach ASTM G155 in einem Atlas Ci 5000 Weatherometer mit einer Bestrahlungsstärke von 0,75 $W/m^2/nm$ bei 340 nm und einem Trocken/- Beregnungszyklus von 102:18 Minuten. Nach einer gegebenen Alterungsdauer erfolgte eine visuelle Beurteilung der Oberfläche auf aufgetretene Schäden.

Die Ermittlung der Transmission an den Mehrschichtaufbauten erfolgte an einem Lambda 900 Spektralphotometer der Firma Perkin Elmer mit Photometerkugel nach ISO 13468-2.

Die Ermittlung der Trübung / des Haze an den Mehrschichtaufbauten erfolgte nach ASTM D 1003 mit einem Haze Gard Plus der Firma Byk-Gardner.

Die Ermittlung des Gelbwerts / des Yellowness Index (YI) an den Mehrschichtaufbauten erfolgte nach ASTM E 313 mit einem Spektrometer HunterLAB UltraScan Pro.

Die Schichtdicken der Einzelschichten der Mehrschichtaufbauten wurden über Weißlichtinterferenz mit Hilfe des Messgerätes Eta SD 30 der Firma Eta Optik GmbH, Deutschland, bestimmt.

Die Haftfestigkeit der Mehrschichtaufbauten wurde durch einen Klebebandabriss (verwendetes Klebeband 3M Scotch 610-1PK) mit Gitterschnitt (analog zu ISO 2409 bzw. ASTM D 3359) sowie durch einen Klebebandabriss nach 1 h Lagerung in kochendem Wasser ermittelt. Die Bewertung der Haftfestigkeit erfolgte gemäß ISO 2409 (0 ... keine Delamination; 5 ... großflächige Delamination).

Die beschichtete Seite der Mehrschichtaufbauten wurde mittels eines Taber Abraser Modell 5131 der Firma Erichsen gemäß ISO 52347 bzw. ASTM D 1044 unter Verwendung der CS10F Räder (Generation 4; 500g Auflagegewicht; 1000 Zyklen) beansprucht. Die Ermittlung der Trübung vor und nach der Beanspruchung ermöglicht durch Differenzbildung die Berechnung der Δ Trübung.

Ein Messwert für die UV-Absorption ist die optische Dichte des betreffenden Schichtaufbaus auf dem thermoplastischen Träger bei 340 nm, nachfolgend als OD340 bezeichnet. Diese kann beispielsweise mit einem Spektralphotometer Perkin Elmer Lambda 900 ermittelt werden. Die OD340 wird aus dem spektralen Transmissionsgrad T bei der Wellenlänge 340 nm nach folgender Formel bestimmt:

$$OD340 = \log_{10}\left(\frac{T_{sub}}{T_{ss}}\right)$$

mit $T_{sub}$ als Transmissionsgrad des unbeschichteten thermoplastischen Trägers und $T_{ss}$ als Transmissionsgrad des beschichteten thermoplastischen Trägers.

**Abscheideparameter zur Herstellung der Mehrschichtaufbauten auf dem thermoplastischen Trägermaterial (Tabelle 1)**

Bei dem Vergleich 1 wurde die Deckschicht in mehreren Stufen auf die UV-Schutzschicht aufgetragen. Diese Stufen wurden durch die unten angeführte Regulierung des Sauerstoff-Flusses erreicht. Bei dem Vergleich 2 wurde der Sauerstoff-Fluss bei der Abscheidung der Deckschicht konstant gehalten. Beim Beispiel 1 wurde der Sauerstoff-Fluss kontinuierlich, während der Abscheidung der Deckschicht erhöht, wodurch sich ein Sauerstoff-Gradient in der Deckschicht ausbildet.

Tabelle 1:

| | Parameter zur Schichtabscheidung | Einheit | Vergleich 1 | Vergleich 2 | Beispiel 1 |
|---|---|---|---|---|---|
| Schicht 2 | HMDSO-Fluss | g/h | 200 | 200 | 200 |
| | Sauerstoff-Fluss | sl/min | 4,14 | 4,14 | 4,14 |
| | Leistung | W | 2 x 3000 | 2 x 3000 | 2 x 3000 |
| | Puls | ms | cw | cw | cw |
| | Beschichtungsdauer | s | 5 | 5 | 5 |
| Schicht 3 | Diethylzink-Fluss | g/h | 16,5 | 16,5 | 16,5 |
| | Sauerstoff-Fluss | sl/min | 1,00 | 1,00 | 1,00 |
| | Leistung | W | 2 x 1000 | 2 x 1000 | 2 x 1000 |
| | Puls | ms | cw | cw | cw |
| | Beschichtungsdauer | s | 120 | 210 | 180 |
| Schicht 4 | HMDSO-Fluss | g/h | 200 | 200 | 200 |

| | | | | | |
|---|---|---|---|---|---|
| | Sauerstoff-Fluss | sl/min | Stufen:<br>0 bis 1,0;<br>2,5;<br>5,0 | 4,14 | Gradient:<br>0 bis 4,0 |
| | Leistung | W | 2 x 3000 | 2 x 3000 | 2 x 3000 |
| | Puls | ms | cw | cw | cw |
| | Beschichtungsdauer | s | 3 x 10 | 25 | 25 |

**Ergebnisse (Tabelle 2)**

| Eigenschaft | Einheit | Vergleich 1 | Vergleich 2 | Beispiel 1 |
|---|---|---|---|---|
| Dicke der Schicht 2 | µm | 1,0 | 1,0 | 1,0 |
| Dicke der Schicht 3 | µm | 0,4 | 0,7 | 0,6 |
| Dicke der Schicht 4 | µm | 4,0 | 5,0 | 5,0 |
| Transmission | % | 89,0 | 88,6 | 89,1 |
| OD340 | | 1,7 | 2,7 | 2,9 |
| Trübung (initial) | % | 1,2 | 1,8 | 1,6 |
| Trübung nach 4000 h | % | 4,5 | 6,2 | 3,8 |
| Gelbwert (initial) | [ ] | 0,9 | 2,4 | 1,8 |
| Gelbwert nach 4000 h | [ ] | 6,5 | 6,2 | 5,0 |
| Visuelle Evaluierung | [ ] | Risse | Risse | keine Risse |
| Δ Trübung nach 1000 Zyklen (Taber Abrasion Test) | % | 2,6 | 2,3 | 2,4 |
| Haftfestigkeit der Schichten 2 bis 4 auf Schicht 1 (initial) | | 0 | 0 | 0 |
| Haftfestigkeit der Schichten 2 bis 4 auf Schicht 1 (1h Kochtest) | | 0 | 0 | 0 |

Überraschenderweise wurde nun gefunden, dass die Abscheidung einer Deckschicht mit sich kontinuierlich änderndem Sauerstoff-Gehalt in der Schicht zu einer deutlich verbesserten Alterungsstabilität führt im Vergleich zu einem konstanten oder stufenweise ansteigendem Sauerstoffgehalt in der Deckschicht. So sind sowohl die Trübungszunahme als auch die Zunahme des Gelbwerts nach Alterung bei dem Beispiel 1 geringer ausgefallen als bei den Vergleichen 1 und 2. Weiterhin weisen die Vergleiche nach der Alterung Risse auf, wohingegen die Deckschicht im Beispiel 1 vollkommen rissfrei und somit intakt ist. Die Abriebprüfung zeigt mit Werten kleiner 3% in der Trübungszunahme sogar eine Verbesserung gegenüber heute verwendeten Nassbeschichtungen, die im Flutverfahren aufgetragen werden. Die optische Dichte bei 340nm liegt mit 2,9 beim Beispiel 1 auf einem hohen und somit bevorzugten Niveau, wodurch thermoplastische Trägermaterialien ausreichend geschützt werden.

Die Ermittlung der stöchiometrischen Verhältnisse von Zink zu Sauerstoff in der Schicht 3 erfolgte mittels

Röntgenphotoelektronenspektroskopie (ESCA) an Schichten, die auf ein Aluminiumblech unter Nutzung der nachfolgenden Parameter abgeschieden wurden (Tabelle 3)

Tabelle 3:.

| Parameter zur Schichtabscheidung | Einheit | Beispiel 2 | Beispiel 3 | Beispiel 4 | Beispiel 5 | Beispiel 6 |
|---|---|---|---|---|---|---|
| Diethylzink-Fluss | g/h | 34,3 | 37,6 | 37,0 | 33,7 | 34,3 |
| Sauerstoff-Fluss | sl/min | 2,6 | 1,8 | 1,1 | 0,5 | 0,2 |
| Leistung | W | 2 x 1000 | 2 x 1000 | 2 x 1000 | 2 x 1000 | 2 x 1000 |
| Puls | ms | Cw | cw | cw | cw | cw |
| Beschichtungsdauer | s | 100 | 120 | 100 | 90 | 60 |
| Schichtdicke | μm | 0,41 | 0,58 | 0,48 | 0,46 | 0,50 |
| Zink/Sauerstoff-Verhältnis | | 1,30 | 1,38 | 1,43 | 1,34 | 1,20 |

Überraschender Weise wurde gefunden, dass das stöchiometrische Verhältnis von Zink zu Sauerstoff in der Schicht 3 unabhängig von dem Verhältnis der Ausgangsgasflüsse von Zink und Sauerstoff ist und bei einem Wert zwischen 1,2 und 1,43 liegt. Gerade bei einem stöchiometrischen Verhältnis von Zink zu Sauerstoff > 1 werden gute und stabile Alterungsbeständigkeiten erreicht.

**Patentansprüche**

**1.** Multilagenaufbau enthaltend die Schichten in der nachfolgenden Reihenfolge:

1. ein thermoplastisches Trägermaterial,
2. eine Sperrschicht, wobei die Sperrschicht aus einem Si-basierten Präkursor gebildet wird, ausgewählt aus der Gruppe enthaltend Silane, Disilane, Tetramethyldisiloxan (TMDSO), Hexamethyldisiloxan (HMDSO), Tetraethylorthosilikat (TEOS), Hexamethyldisilane, Octamethylcyclotetrasiloxan (D4) oder Tetramethylcyclotetrasiloxane,
3. eine UV-Schutzschicht auf Basis eines Metalloxids ausgewählt ist aus der Gruppe Titandioxid, Ceroxid oder Zinkoxid.
4. eine Deckschicht, wobei die Deckschicht aus einem Si-basierten Präkursor gebildet wird ausgewählt aus der Gruppe enthaltend Silane, Disilane, Tetramethyldisiloxan (TMDSO), Hexamethyldisiloxan (HMDSO), Tetraethylorthosilikat (TEOS), Hexamethyldisilane, Octamethylcyclotetrasiloxan (D4) oder Tetramethylcyclotetrasiloxane, wobei der Sauerstoffgehalt der Deckschicht nahe der UV-Lichtabsorbierenden Schicht geringer als auf der entgegengesetzten Seite der Deckschicht und der Kohlenstoffgehalt nahe der UV-Lichtabsorbierenden Schicht höher ist als auf der entgegengesetzten Seite der Deckschicht.

**2.** Ein Multilagenaufbau nach Anspruch 1, wobei das thermoplastische Trägermaterial ausgewählt ist aus der Gruppe enthaltend Polycarbonat, Co-Polycarbonat, Polyestercarbonat, Polystyrol, Styrol-Copolymere, aromatische Polyester wie Polyethylenterephthalat (PET), PET-Cyclohexandimethanol-Copolymer (PETG), Polyethylen-naphthalat (PEN), Polybutylenterephthalat (PBT), aliphatische Polyolefine wie Polypropylen oder Polyethylen, cyclisches Polyolefin, Poly- oder Copolyacrylate und Poly- oder Copolymethacrylat wie Poly- oder Copolymethylmethacrylate (wie PMMA) sowie Copolymere mit Styrol wie transparentes Polystyrolacrylnitril (PSAN), thermoplastische Polyurethane, Polymere auf Basis von zyklischen Olefinen, Polycarbonat Blends mit olefinischen Copolymeren oder Pfropfpolymeren, wie beispielsweise Styrol/Acrylnitril Copolymeren oder Mischungen von mindestens zwei der genannten Polymere, bevorzugt Polycarbonat oder Polymethylmethacrylat.

**3.** Ein Multilagenaufbau nach Anspruch 1 oder 2, wobei die Sperrschicht aus einem Präkursor gebildet wird ausgewählt aus der Gruppe, Hexamethyldisiloxan (HMDSO), Tetraethylorthosilikat (TEOS) oder Octamethylcyclotetrasiloxan (D4)

**4.** Ein Multilagenaufbau nach einem oder mehreren der vorhergehenden Ansprüche, wobei die Sperrschicht eine Dicke von 0,5 μm bis 2 μm aufweist.

**5.** Ein Multilagenaufbau nach einem oder mehreren der vorhergehenden Ansprüche, wobei die UV-Lichtabsorbierende Schicht aus Diethylzink als Präkursor gebildet wird.

**6.** Ein Multilagenaufbau nach Anspruch 5, wobei die UV-Lichtabsorbierende Schicht eine Dicke aufweist von ≥ 100 nm, bevorzugt ≥ 300 nm und besonders bevorzugt ≥ 600 nm.

**7.** Ein Multilagenaufbau nach Anspruch 5, wobei die UV-Lichtabsorbierende Schicht eine optische Dichte bei 340 nm von > 2, bevorzugt > 2,5 aufweist.

**8.** Ein Multilagenaufbau nach einem oder mehreren der vorhergehenden Ansprüche , wobei die Deckschicht aus einem Präkursor gebildet wird ausgewählt aus der Gruppe enthaltend Hexamethyldisiloxan (HMDSO), Tetraethylorthosilikat (TEOS) und Octamethylcyclotetrasiloxan (D4)

**9.** Multilagenaufbau nach Anspruch 8, wobei der Sauerstoff- und Kohlenstoffgehalt der Deckschicht einen kontinuierlichen Gradienten durchlaufen.

**10.** Multilagenaufbau nach Anspruch 8, wobei die Deckschicht eine Dicke aufweist von > 1 μm, bevorzugt > 2 μm, und ganz besonders bevorzugt > 3 μm.

**11.** Verfahren zur Herstellung eines Multilagenaufbaus nach Anspruch 1, wobei mindestens eine Schicht ausgewählt aus der Sperrschicht, UV-Lichtabsorbierenden Schicht und Deckschicht mittels plasmaunterstützter chemischer oder physikalischer Gasphasenabscheidung, bevorzugt mittels plasmaunterstützter chemischer Gasphasenabscheidung, abgeschieden wurde.

**12.** Verfahren zur Herstellung eines Multilagenaufbaus nach Anspruch 11, wobei zur Abscheidung die Duo-Plasmaline als Plasmaquelle genutzt wurde.

**13.** Verfahren zur Herstellung eines Multilagenaufbaus nach Anspruch 12, wobei die Frequenz der Plasmaquelle 13,56 MHz, 27,12 MHz, 915,0 MHz, 2,45 GHz oder 5,8 GHz, bevorzugt bei 2,45 GHz liegt.

**14.** Verfahren zur Herstellung eines Multilagenaufbaus nach Anspruch 12, wobei der Quotient aus Pumpenleistung in $m^3/h$ und dem Volumen der Vakuumkammer in $m^3$ größer ist als 10.000 1/h, bevorzugt größer 75.000 1/h.

**15.** Verfahren zur Herstellung eines Multilagenaufbaus nach Anspruch 12 wobei der Druck in der Vakuumkammer bei maximaler Pumpleistung sowie bei maximalen Gasflüssen von Präkursoren, Trägergasen und Reaktivgasen in Abwesenheit des zur Abscheidung benötigen Plasmas kleiner 1,5 mbar, besonders bevorzugt kleiner 1 mbar und ganz besonders bevorzugt kleiner 0,5 mbar ist.

**16.** Multilagenaufbau hergestellt nach einem Verfahren nach einem der Ansprüche 11 bis 15.

**17.** Verwendung eines Multilagenaufbaus nach Anspruch 1 bis 11 für Verscheibungen und Blenden im Verkehrswesen sowie im Bauwesen, für Bauteile im E&E- sowie IT-Sektor sowie Folien und Platten.

**18.** Formteile enthaltend einen Multilagenaufbau nach einem der Ansprüche 1 bis 11.

**19.** Verscheibungen, Blenden im Verkehrswesen sowie Bauteile für Anwendung im E&E- sowie IT-Sektor sowie Folien und Platten enthaltend einen Multilagenaufbau nach einem der Ansprüche 1 bis 11.

## Claims

**1.** Multilayer structure containing the layers in the following order:

1. a thermoplastic support material,
2. a barrier layer, where the barrier layer is formed from an Si-based precursor selected from the group consisting of silanes, disilanes, tetramethyldisiloxane (TMDSO), hexamethyldisiloxane (HMDSO), tetraethyl orthosilicate (TEOS), hexamethyldisilanes, octamethylcyclotetrasiloxane (D4) and tetramethylcyclotetrasiloxanes,
3. a UV protection layer based on a metal oxide is selected from the group consisting of titanium dioxide, cerium

oxide and zinc oxide,

4. a covering layer, where the covering layer is formed from an Si-based precursor selected from the group consisting of silanes, disilanes, tetramethyldisiloxane (TMDSO), hexamethyldisiloxane (HMDSO), tetraethyl orthosilicate (TEOS), hexamethyldisilanes, octamethylcyclotetrasiloxane (D4) and tetramethylcyclotetrasiloxanes, where the oxygen content of the covering layer close to the UV light-absorbing layer is less than on the opposite side of the covering layer and the carbon content near the UV light-absorbing layer is higher than on the opposite side of the covering layer.

**2.** Multilayer structure according to Claim 1, wherein the thermoplastic support material is selected from the group consisting of polycarbonate, copolycarbonate, polyester carbonate, polystyrene, styrene copolymers, aromatic polyesters such as polyethylene terephthalate (PET), PET-cyclohexanedimethanol copolymer (PETG), polyethylene naphthalate (PEN), polybutylene terephthalate (PBT), aliphatic polyolefins such as polypropylene or polyethylene, cyclic polyolefin, polyacrylates or copolyacrylates and polymethacrylate or copolymethacrylate e.g. polymethyl or copolymethyl methacrylates (e.g. PMMA), and copolymers with styrene such as transparent polystyrene-acrylonitrile (PSAN), thermoplastic polyurethanes, polymers based on cyclic olefins, polycarbonate blends with olefinic copolymers or graft polymers, for example styrene-acrylonitrile copolymers, and mixtures of at least two of the polymers mentioned, preferably polycarbonate or polymethyl methacrylate.

**3.** Multilayer structure according to Claim 1 or 2, wherein the barrier layer is formed from a precursor selected from the group consisting of hexamethyldisiloxane (HMDSO), tetraethyl orthosilicate (TEOS) and octamethylcyclotetrasiloxane (D4).

**4.** Multilayer structure according to one or more of the preceding claims, wherein the barrier layer has a thickness of from 0.5 μm to 2 μm.

**5.** Multilayer structure according to one or more of the preceding claims, wherein the UV light-absorbing layer is formed from diethylzinc as precursor.

**6.** Multilayer structure according to Claim 5, wherein the UV light-absorbing layer has a thickness of ≥ 100 nm, preferably ≥ 300 nm and particularly preferably ≥ 600 nm.

**7.** Multilayer structure according to Claim 5, wherein the UV light-absorbing layer has an optical density at 340 nm of > 2, preferably > 2.5.

**8.** Multilayer structure according to one or more of the preceding claims, wherein the covering layer is formed from a precursor selected from the group consisting of hexamethyldisiloxane (HMDSO), tetraethyl orthosilicate (TEOS) and octamethylcyclotetrasiloxane (D4) .

**9.** Multilayer structure according to Claim 8, wherein the oxygen and carbon contents of the covering layer have a continuous gradient.

**10.** Multilayer structure according to Claim 8, wherein the covering layer has a thickness of > 1 μm, preferably > 2 μm, and very particularly preferably > 3 μm.

**11.** Process for producing a multilayer structure according to Claim 1, wherein at least one layer selected from among the barrier layer, UV light-absorbing layer and covering layer is deposited by means of plasma-enhanced chemical or physical vapor deposition, preferably by means of plasma-enhanced chemical vapor deposition.

**12.** Process for producing a multilayer structure according to Claim 11, wherein the Duo-Plasmaline is utilized as plasma source for the deposition.

**13.** Process for producing a multilayer structure according to Claim 12, wherein the frequency of the plasma source is 13.56 MHz, 27.12 MHz, 915.0 MHz, 2.45 GHz or 5.8 GHz, preferably 2.45 GHz.

**14.** Process for producing a multilayer structure according to Claim 12, wherein the ratio of pump power in $m^3$/h to the volume of the vacuum chamber in $m^3$ is greater than 10 000 1/h, preferably greater than 75 000 1/h.

**15.** Process for producing a multilayer structure according to Claim 12, wherein the pressure in the vacuum chamber

at maximum pump power and at maximum gas flows of precursors, carrier gases and reactive gases in the absence of the plasma required for deposition is less than 1.5 mbar, particularly preferably less than 1 mbar and very particularly preferably less than 0.5 mbar.

**16.** Multilayer structure produced by a process according to any of Claims 11 to 15.

**17.** Use of a multilayer structure according to any of Claims 1 to 11 for glazing and screens in traffic means and also in building and construction, for components in the E&E and IT sector and also films and plates.

**18.** Shaped parts containing a multilayer structure according to any of Claims 1 to 11.

**19.** Glazing components, screens in traffic means and components for use in the E&E and IT sector and also films and plates containing a multilayer structure according to any of Claims 1 to 11.

## Revendications

**1.** Structure multicouche contenant les couches dans l'ordre suivant :

1. un matériau support thermoplastique,
2. une couche de blocage, la couche de blocage étant formée à partir d'un précurseur à base de Si choisi dans le groupe contenant les silanes, les disilanes, le tétraméthyldisiloxane (TMDSO), l'hexaméthyldisiloxane (HMDSO), le tétraéthylorthosilicate (TEOS), les hexaméthyldisilanes, l'octaméthylcyclotétrasiloxane (D4) ou les tétraméthylcyclotétrasiloxanes,
3. une couche de protection contre les UV à base d'un oxyde métallique choisi dans le groupe constitué par le dioxyde de titane, l'oxyde de cérium ou l'oxyde de zinc,
4. une couche de recouvrement, la couche de recouvrement étant formée à partir d'un précurseur à base de Si choisi dans le groupe contenant les silanes, les disilanes, le tétraméthyldisiloxane (TMDSO), l'hexaméthyldisiloxane (HMDSO), le tétraéthylorthosilicate (TEOS), les hexaméthyldisilanes, l'octaméthylcyclotétrasiloxane (D4) ou les tétraméthylcyclotétrasiloxanes, la teneur en oxygène de la couche de recouvrement à proximité de la couche absorbant la lumière UV étant plus faible que sur le côté opposé de la couche de recouvrement et la teneur en carbone à proximité de la couche absorbant la lumière UV étant plus élevée que sur le côté opposé de la couche de recouvrement.

**2.** Structure multicouche selon la revendication 1, dans laquelle le matériau support thermoplastique est choisi dans le groupe contenant le polycarbonate, le co-polycarbonate, le polyester-carbonate, le polystyrène, les copolymères de styrène, les polyesters aromatiques tels que le polyéthylène-téréphthalate (PET), le copolymère de PET-cyclohexanediméthanol (PETG), le polyéthylène-naphtalate (PEN), le polybutylène-téréphtalate (PBT), les polyoléfines aliphatiques telles que le polypropylène ou le polyéthylène, les polyoléfines cycliques, les poly- ou copolyacrylates et les poly- ou copolyméthacrylates tels que les poly- ou copolyméthacrylates de méthyle (tels que le PMMA), ainsi que les copolymères avec du styrène tels que le polystyrène-acrylonitrile transparent (PSAN), les polyuréthanes thermoplastiques, les polymères à base d'oléfines cycliques, les mélanges de polycarbonate avec des copolymères oléfiniques ou des polymères greffés, tels que par exemple les copolymères de styrène/acrylonitrile ou les mélanges d'au moins deux des polymères mentionnés, de préférence le polycarbonate ou le polyméthacrylate de méthyle.

**3.** Structure multicouche selon la revendication 1 ou 2, dans laquelle la couche de blocage est formée à partir d'un précurseur choisi dans le groupe constitué par l'hexaméthyldisiloxane (HMDSO), le tétraéthylorthosilicate (TEOS) ou l'octaméthylcyclotétrasiloxane (D4).

**4.** Structure multicouche selon une ou plusieurs des revendications précédentes, dans laquelle la couche de blocage présente une épaisseur de 0,5 $\mu$m à 2 $\mu$m.

**5.** Structure multicouche selon une ou plusieurs des revendications précédentes, dans laquelle la couche absorbant la lumière UV est formée à partir de diéthyl-zinc en tant que précurseur.

**6.** Structure multicouche selon la revendication 5, dans laquelle la couche absorbant la lumière UV présente une épaisseur $\geq$ 100 nm, de préférence $\geq$ 300 nm et de manière particulièrement préférée $\geq$ 600 nm.

7. Structure multicouche selon la revendication 5, dans laquelle la couche absorbant la lumière UV présente une densité optique à 340 nm > 2, de préférence > 2,5.

8. Structure multicouche selon une ou plusieurs des revendications précédentes, dans laquelle la couche de recouvrement est formée à partir d'un précurseur choisi dans le groupe contenant l'hexaméthyldisiloxane (HMDSO), le tétraéthylorthosilicate (TEOS) et l'octaméthylcyclotétrasiloxane (D4).

9. Structure multicouche selon la revendication 8, dans laquelle la teneur en oxygène et en carbone de la couche de recouvrement suit un gradient continu.

10. Structure multicouche selon la revendication 8, dans laquelle la couche de recouvrement présente une épaisseur > 1 μm, de préférence > 2 μm et de manière tout particulièrement préférée > 3 μm.

11. Procédé de fabrication d'une structure multicouche selon la revendication 1, dans lequel au moins une couche choisie parmi la couche de blocage, la couche absorbant la lumière UV et la couche de recouvrement a été déposée par dépôt chimique ou physique en phase vapeur assisté par plasma, de préférence par dépôt chimique en phase vapeur assisté par plasma.

12. Procédé de fabrication d'une structure multicouche selon la revendication 11, dans lequel le Duo-Plasmaline a été utilisé en tant que source de plasma pour le dépôt.

13. Procédé de fabrication d'une structure multicouche selon la revendication 12, dans lequel la fréquence de la source de plasma est de 13,56 MHz, 27,12 MHz, 915,0 MHz, 2,45 GHz ou 5,8 GHz, de préférence de 2,45 GHz.

14. Procédé de fabrication d'une structure multicouche selon la revendication 12, dans lequel le quotient de la puissance de pompage en $m^3$/h et du volume de la chambre sous vide en $m^3$ est supérieur à 10 000 1/h, de préférence supérieur à 75 000 1/h.

15. Procédé de fabrication d'une structure multicouche selon la revendication 12, dans lequel la pression dans la chambre sous vide à la puissance de pompage maximale et aux débits de gaz maximaux des précurseurs, des gaz vecteurs et des gaz réactifs en l'absence du plasma nécessaire pour le dépôt est inférieure à 1,5 mbar, de manière particulièrement préférée inférieure à 1 mbar et de manière tout particulièrement préférée inférieure à 0,5 mbar.

16. Structure multicouche fabriquée par un procédé selon l'une quelconque des revendications 11 à 15.

17. Utilisation d'une structure multicouche selon les revendications 1 à 11 pour des vitrages et des panneaux dans le secteur des transports, ainsi que dans le bâtiment, pour des composants dans le secteur de l'énergie renouvelable et des technologies de l'information, ainsi que pour des films et des plaques.

18. Pièces moulées contenant une structure multicouche selon l'une quelconque des revendications 1 à 11.

19. Vitrages, panneaux dans le secteur des transports, ainsi que composants pour une utilisation dans le secteur de l'énergie renouvelable et des technologies de l'information, ainsi que films et plaques contenant une structure multicouche selon les revendications 1 à 11.

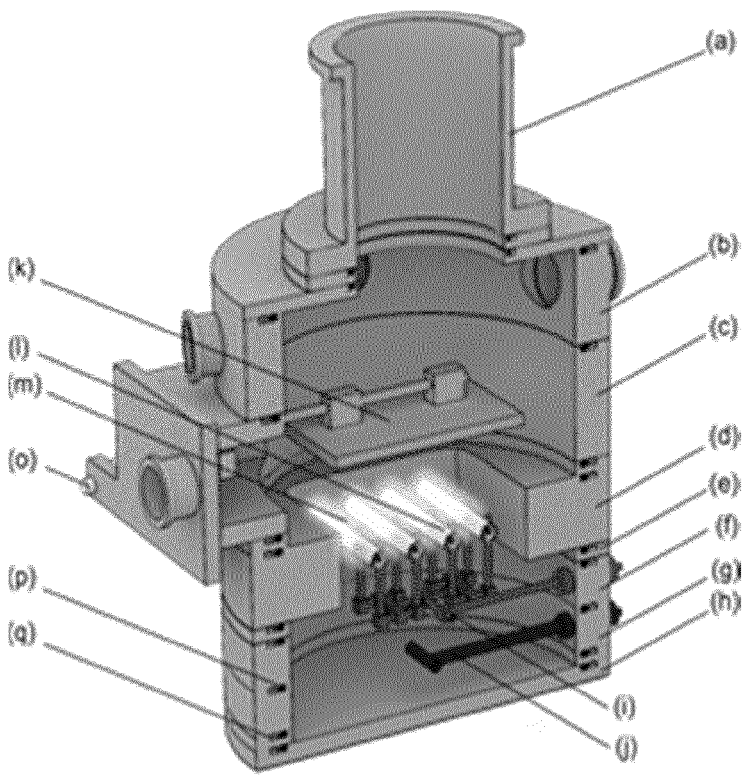


Figur 1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- DE 2650048
- EP 0252870 A
- US 5298587 A
- DE 3413019
- US 4927704 A
- US 5051308 A
- EP 0267679 A
- WO 9713802 A
- EP 887437 A
- DE 10012516
- DE 10153760
- US 5156882 A
- DE 19901834
- EP 2013067210 W
- DE 19924108
- DE 19522865
- FR 2874606
- WO 1999055471 A
- WO 2012143150 A1
- DE 102010006134 A1
- WO 2006002768 A1
- WO 2003038141 A2
- EP 1657281 A
- EP 1582549 A1
- WO 2008037364 A1
- US 3189662 A
- US 3419634 A
- EP 0122535 A1
- WO 2006040087 A1
- DE 2035390 A1
- DE 2248242 A1
- EP 0839623 A1
- WO 9615102 A1
- EP 0500496 A1
- EP 0110221 A
- EP 0110238 A
- EP 0716919 A


### In der Beschreibung aufgeführte Nicht-Patentliteratur


- **NIZARD et al.** Deposition of titanium dioxide from TTIP by plasma enhanced and remote plasma enhanced chemical vapour deposition. *Surface and Coating Technology,* 2008, vol. 202, 4076-4085
- **H. J. FRENCK et al.** Depopsition of TiO2 thin films plasma-enhanced decomposition of tetraisopropyltitanate. *Thin Solid Films,* 1991, vol. 201, 327-335
- **BARRECA et al.** Nucleation and growth of nanophasic CeO2 thin films by plasma enhanced CVD. *Chemical Vapor Deposition,* 2003, vol. 9, 199-206
- **KERSTIN LAU.** Plasmagestützte Aufdampfprozesse für die Herstellung haftfester optischer Beschichtungen auf Bisphenol-A Polycarbonat. *Dissertation,* 2006
- **ANMA, H.** Preparation of zinc oxide thin films deposited by plasma chemical vapor deposition for application to ultraviolet-cut coating. *Japanese Journal of Applied Physics, Part 1: Regular Papers, Short Notes & Review Papers,* 2001, vol. 40 (10), 6099-6103
- **MOUSTAGHFIR, A. et al.** Sputtered zinc oxide coatings: structural study and application to the photoprotection of the polycarbonate. *Surface and Coatings Technology,* 2004, vol. 180 (181), ISSN 0257-8972, 642-645
- **MOUSTAGHFIR, A. et al.** Photostabilization of polycarbonate by ZnO coatings. *Journal of Applied Polymer Science,* 2005, vol. 95 (2), ISSN 0021-8995, 380-385
- **MERLI, S. et al.** Hochrateabscheidung mit einem Mikrowellenplasma Mit Duo-Plasmaline abgeschiedenes Siliziumoxid verleiht Polycarbonat die Kratzfestigkeit von Glas. *Vakuum in Forschung und Praxis,* 2013, vol. 25 (2), ISSN 0947-076, 33-40
- **MERLI, S. et al.** PECVD of Zinc Oxide as UV Protection Coating. *Jahresbericht 2012 des Instituts für Plasmaforschung Universität Stuttgart,* 2012, vol. 46
- **MERLI, S. et al.** Transparent UV- and scratch protective coatings on polycarbonate. *Jahresbericht 2013 des Instituts für Plasmaforschung Universität Stuttgart,* 2013, vol. 14
- **ULLMANNS.** Enzyklopädie der Technischen Chemie. 1980, vol. 19, 280

- **HANS ZWEIFEL.** Plastics Additives Handbook. Hanser Verlag
- **JOHANNABER ; AST.** Kunststoff- Maschinenführer. Hanser Verlag, 2000
- Koextrudierte Folien und Platten: Zukunftsperspektiven, Anforderungen, Anlagen und Herstellung. Qualitätssicherung. VDI-Verlag, 1990
- **E. RÄUCHLE.** *Third International Workshop on microwave Discharges: Fundamentals and Applications,* 20. April 1997
- **W. PETASCH et al.** Duo-Plasmaline - A linearly extended homogenous low pressure plasma source. *Surface and Coatings Technology,* 1997, vol. 93, 112-118
- **G. BENZ.** Plasmapolymerisation: Überblick und Anwendung als Korrosions- und Zerkratzungsschutzschichten. VDI-Verlag GmbH, 1989
- **VERFAHREN, H. FREY.** Vakuumbeschichtung. VDI-Verlag, 1995, vol. 2